# EUROPEAN PATENT SPECIFICATION

(11) **EP 2 108 616 B1**
(45) Date of publication and mention of the grant of the patent: **08.02.2012**
(21) Application number: 09157881.5
(22) Date of filing: 14.04.2009
(51) Int. Cl.: B01J 4/00, C23C 16/22, C23C 16/448, H01L 21/00, F16L 19/02

(54) **Delivery method for a reagent using a reagent dispensing apparatus**
Abgabeverfahren eines Reagens mit einer Reagensabgabevorrichtung
Procédé de distribution de réactif utilisant un appareil distributeur de réactif

(30) Priority: 11.04.2008 US 44083 P; 19.03.2009 US 407322
(43) Date of publication of application: 14.10.2009
(73) Proprietor: Praxair Technology, Inc., Danbury, CT 06810-5113 (US)
(72) Inventor: Peck, John D., West Seneca, NY 14224 (US)
(74) Representative: Schwan - Schwan - Schorer

(56) References cited:
- EP-A- 1 166 900
- US-A- 6 077 356
- US-A1- 2002 108 670

## Description

### Field of the Invention

This invention relates to a method for delivery of a vapor phase reagent to a deposition chamber such as precursors for deposition of materials in the manufacture of semiconductor materials and devices.

### Background of the Invention

High purity chemicals used in the semiconductor and pharmaceutical industries require special packaging to maintain their purity in storage. This is especially true for chemicals that react with air and/or moisture in the air. Such high purity chemicals are typically supplied in containers such as bubblers or ampoules.

Modem chemical vapor deposition and atomic layer deposition tools utilize bubblers or ampoules to deliver precursor chemicals to a deposition chamber. These bubblers or ampoules work by passing a carrier gas through a container of high purity liquid precursor chemical and carrying the precursor vapor along with the gas to the deposition chamber.

The containers are typically manufactured as either one-part (i.e., the top cover or lid is not removable from the base) or two-part (i.e., the top cover or lid is removable from the base and can be attached to the base by bolts) containers. The one-part containers have a high degree of integrity, but are more difficult to clean than the two-part containers. Because the top cover or lid can be removed from the base, the two-part containers are easier to clean but are more difficult to seal and reuse. Easier cleaning allows for the reuse of a two-part container beyond what may be achieved with a one-part container. Reuse of containers is important for minimizing costs and also for environmental concerns.

As integrated circuits have decreased in size, so have the dimensions of the internal components or features. As the sizes decreased, the need for more pure chemicals has correspondingly increased to minimize the effect of impurities. Suppliers therefore, must be able to not only manufacture high purity chemicals, but must also be able to deliver them in a container which will maintain the high purity.

The standard materials of construction for these containers shifted from the delicate quartz containers to stainless steel in the late 1990's. See, for example, U.S. Patent No. 5,607,002. These containers are known in the industry either as bubblers or ampoules and are now routinely constructed of stainless steel, e.g., 316SS. See, for example, U.S. Patent Nos. 3,930,591, 6,029,717 and 7,077,388.

Further, in most cases, it is necessary to heat the ampoule by some means in order to increase the vapor pressure of the precursor and thus increase the amount of chemical in the carrier gas. It is important to monitor the temperature of the liquid precursor chemical inside of the ampoule to control the vapor pressure.

It is also important to know when the liquid precursor chemical inside of the ampoule is close to running out so that it can be changed at the end of a chemical vapor deposition or atomic layer deposition cycle. If the ampoule should run dry in the middle of a cycle, the entire batch of wafers will be ruined resulting in a potential loss of millions of dollars. It is therefore desirable to leave as little liquid precursor chemical as possible inside of the ampoule to avoid wasting the valuable liquid precursor chemical. As the cost of chemical precursors increase, wasting as little chemical as possible becomes more important.

For two-part high-purity chemical containers to gain commercial acceptance, it will be necessary to develop a more reliable seal. U.S. Patent No. 6,905,125 relates to a metal gasket such as C-ring gasket to prevent leakage of fluid from semiconductor manufacturing apparatus. High purity chemicals for the electronics industry require leak-tight containers that are able to withstand high vacuum.

It would be desirable in the art to provide an easy to clean, two-part vapor or liquid phase reagent dispensing apparatus which is capable of maintaining high purity of the precursor chemical and also increasing the usage of the precursor chemical in the apparatus, and correspondingly reducing waste thereof.

### Summary of the Invention

This invention also relates in part to a method for delivery of a vapor phase reagent to a deposition chamber comprising:

providing a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port opening;

said first face seal port opening having a carrier gas feed inlet fitting connected thereto;

an adapter comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the first face seal port opening and an outlet end adjacent to the bottom wall member;

said first face seal port opening and said carrier gas feed inlet fitting having opposing surfaces, wherein the opposing surfaces are not in contact with one another;

said metal face seal gasket being aligned and in contact with the opposing surfaces of said first face seal port opening and said carrier gas feed inlet fitting;

fastening means for securing the carrier gas feed inlet fitting to said first face seal port opening through the opposing surfaces and said metal face seal gasket;

a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough;

said second face seal port opening having a vapor phase reagent outlet fitting connected thereto, through which said vapor phase reagent can be dispensed from said apparatus; and

a vapor phase reagent discharge line extending and exteriorly from the vapor phase reagent outlet fitting for removal of vapor phase reagent from said inner gas volume above the fill level, the vapor phase reagent discharge line optionally containing one or more vapor phase reagent flow control valves therein for control of flow of the vapor phase reagent therethrough;

adding source chemical to said vapor phase reagent dispensing apparatus;

heating the source chemical in said vapor phase reagent dispensing apparatus to a temperature sufficient to vaporize the source chemical to provide vapor phase reagent;

feeding a carrier gas into said vapor phase reagent dispensing apparatus through said carrier gas feed line and said tube;

withdrawing the vapor phase reagent and carrier gas from said vapor phase reagent dispensing apparatus through said vapor phase reagent discharge line; and

feeding the vapor phase reagent and carrier gas into said deposition chamber.

This invention yet further relates in part to a method for delivery of a vapor phase reagent to a deposition chamber comprising:

providing a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having an inert gas feed inlet fitting connected thereto, through which an inert gas can be fed into the inner gas volume above the fill level to pressurize the inner gas volume above the fill level;

said second face seal port opening having a liquid phase reagent outlet fitting connected thereto;

an adapter comprising a metal face seal gasket joined to a tube that extends through the second face seal port opening and the inner gas volume into the source chemical and through which liquid phase reagent can be dispensed from said apparatus, said tube having an outlet end adjacent to the second face seal port opening and an inlet end adjacent to the bottom wall member;

said second face seal port opening and said liquid phase reagent outlet fitting having opposing surfaces, wherein the opposing surfaces are not in contact with one another;

said metal face seal gasket being aligned and in contact with the opposing surfaces of said second face seal port opening and said liquid phase reagent outlet fitting;

fastening means for securing the liquid phase reagent outlet fitting to said second face seal port opening through the opposing surfaces and said metal face seal gasket;

an inert gas feed line extending exteriorly from the inert gas feed inlet fitting for delivery of inert gas into said inner gas volume above the fill level, the inert gas feed line containing one or more inert gas flow control valves therein for control of flow of the inert gas therethrough; and

a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough;

adding liquid phase reagent to said liquid phase reagent dispensing apparatus;

optionally heating a solid source chemical in said liquid phase reagent dispensing apparatus to a temperature sufficient to melt the solid source chemical to provide liquid phase reagent;

feeding an inert gas into said liquid phase reagent dispensing apparatus through said inert gas feed line;

withdrawing the liquid phase reagent from said liquid phase reagent dispensing apparatus through said tube and said liquid phase reagent discharge line;

providing a vaporization apparatus comprising:

a vessel configured to form an internal vessel compartment to vaporize the liquid phase reagent;

said liquid phase reagent discharge line connecting the liquid phase reagent dispensing apparatus to said vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing one or more carrier gas flow control valves therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line optionally containing one or more vapor phase reagent flow control valves therein for control of flow of the vapor phase reagent therethrough;

feeding the liquid phase reagent into said vaporization apparatus;

heating the liquid phase reagent in said vaporization apparatus to a temperature sufficient to vaporize the liquid phase reagent to provide said vapor phase reagent;

feeding a carrier gas into said vaporization apparatus through said carrier gas feed line;

withdrawing the vapor phase reagent and carrier gas from said vaporization apparatus through said vapor phase reagent discharge line; and

feeding the vapor phase reagent and carrier gas into said deposition chamber.

This invention further relates in part to a method for delivery of a vapor phase reagent to a deposition chamber comprising:

providing a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, a carrier gas feed inlet opening and a vapor phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the carrier gas feed inlet opening, the face seal opening, the face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the carrier gas feed inlet opening and an outlet end adjacent to the bottom wall member;

said carrier gas feed inlet opening having a carrier gas feed inlet fitting attached thereto;

said carrier gas feed inlet opening and said carrier gas feed inlet fitting having opposing surfaces, wherein the opposing surfaces are not in contact with one another;

said metal face seal gasket being aligned and in contact with the opposing surfaces of said carrier gas feed inlet opening and said carrier gas feed inlet fitting;

fastening means for securing the carrier gas feed inlet fitting to said carrier gas feed inlet opening through the opposing surfaces and said metal face seal gasket;

annular space between the outer wall of said tube and the inner walls of said carrier gas feed inlet opening, said face seal opening and said face seal port opening, through which said vapor phase reagent can be dispensed from said apparatus through said vapor phase reagent outlet opening;

a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and

a vapor phase reagent discharge line extending exteriorly from the vapor phase reagent outlet opening for removal of vapor phase reagent from said inner gas volume above the fill level, the vapor phase reagent discharge line optionally containing one or more vapor phase reagent flow control valves therein for control of flow of the vapor phase reagent therethrough;

adding source chemical to said vapor phase reagent dispensing apparatus;

heating the source chemical in said vapor phase reagent dispensing apparatus to a temperature sufficient to vaporize the source chemical to provide vapor phase reagent;

feeding a carrier gas into said vapor phase reagent dispensing apparatus through said carrier gas feed line and said tube;

withdrawing the vapor phase reagent and carrier gas from said vapor phase reagent dispensing apparatus through said vapor phase reagent discharge line; and

feeding the vapor phase reagent and carrier gas into said deposition chamber.

This invention also relates in part to a method for delivery of a vapor phase reagent to a deposition chamber comprising:

providing a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, an inert gas feed inlet opening and a liquid phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the liquid phase reagent outlet opening, the face seal opening, the face seal port opening and the inner gas volume into the source chemical and through which liquid phase reagent can be dispensed from said apparatus, said tube having an outlet end adjacent to the liquid phase reagent outlet opening and an inlet end adjacent to the bottom wall member;

said liquid phase reagent outlet opening having a liquid phase reagent outlet fitting connected thereto;

said liquid phase reagent outlet opening and said liquid phase reagent outlet fitting having opposing surfaces, wherein the opposing surfaces are not in contact with one another;

said metal face seal gasket being aligned and in contact with the opposing surfaces of said liquid phase reagent outlet opening and said liquid phase reagent outlet fitting;

fastening means for securing the liquid phase reagent outlet fitting to said liquid phase reagent outlet opening through the opposing surfaces and said metal face seal gasket;

annular space between the outer wall of said tube and the inner walls of said liquid phase reagent outlet opening, said face seal opening and said face seal port opening, through which an inert gas can be fed through the inert gas feed inlet opening into the inner gas volume above the fill level to pressurize the inner gas volume above the fill level;

an inert gas feed line extending exteriorly from the inert gas feed inlet opening for delivery of inert gas into said inner gas volume above the fill level, the inert gas feed line containing one or more inert gas flow control valves therein for control of flow of the inert gas therethrough; and

a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough;

adding liquid phase reagent to said liquid phase reagent dispensing apparatus;

optionally heating a solid source chemical in said liquid phase reagent dispensing apparatus to a temperature sufficient to melt the solid source chemical to provide liquid phase reagent;

feeding an inert gas into said liquid phase reagent dispensing apparatus through said inert gas feed line;

withdrawing the liquid phase reagent from said liquid phase reagent dispensing apparatus through said tube and said liquid phase reagent discharge line;

providing a vaporization apparatus comprising:

a vessel configured to form an internal vessel compartment to vaporize the liquid phase reagent;

said liquid phase reagent discharge line connecting the liquid phase reagent dispensing apparatus to said vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing one or more carrier gas flow control valves therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line optionally containing one or more vapor phase reagent flow control valves therein for control of flow of the vapor phase reagent therethrough;

feeding the liquid phase reagent into said vaporization apparatus;

heating the liquid phase reagent in said vaporization apparatus to a temperature sufficient to vaporize the liquid phase reagent to provide said vapor phase reagent;

feeding a carrier gas into said vaporization apparatus through said carrier gas feed line;

withdrawing the vapor phase reagent and carrier gas from said vaporization apparatus through said vapor phase reagent discharge line; and

feeding the vapor phase reagent and carrier gas into said deposition chamber.

Other aspects, features and embodiments of the invention will be more fully apparent from the ensuing disclosure and appended claims.

### Brief Description of the Drawings

Fig. 1 is a schematic representation of a vapor phase reagent dispensing apparatus with no dip tube, a vapor phase reagent dispensing apparatus with a bubbler tube, and a liquid phase reagent dispensing apparatus with a dip tube, all shown in partial cross-section.

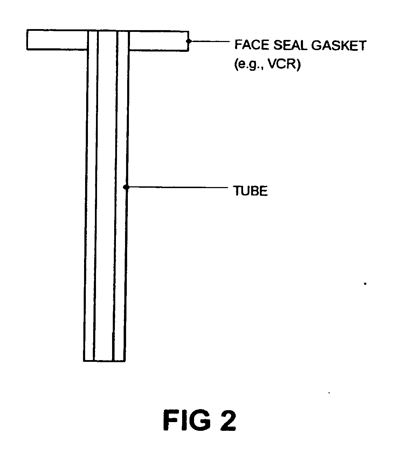

Fig. 2 is a schematic representation of an adapter (i.e., metal face seal gasket and tube) shown in cross-section.

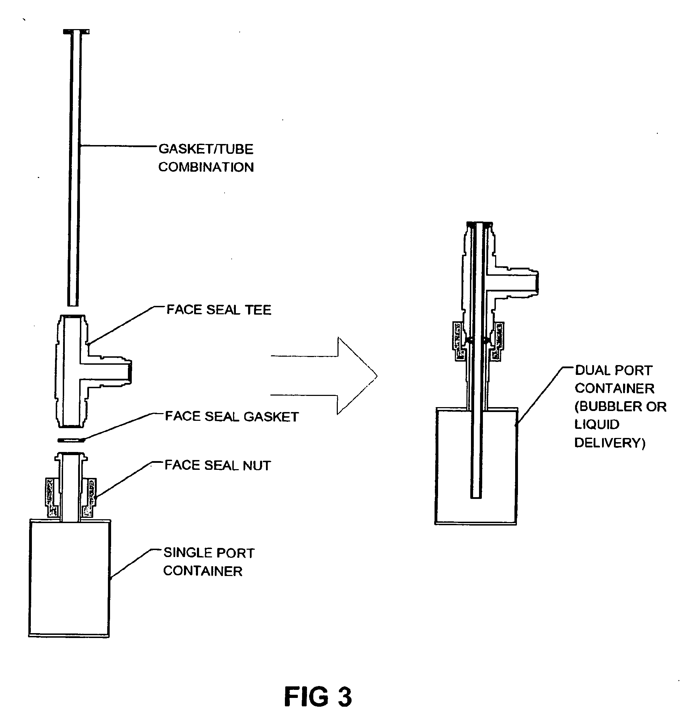

Fig. 3 is a schematic representation of a single port container converted to a dual port container with a tube, shown in cross-section.

Fig. 4 is a schematic representation of components that can be used to assemble a metal face seal gasket connection without an adapter, shown in cross-section.

Fig. 5 is a schematic representation of components that can be used to assemble a metal face seal gasket connection using an adapter, shown in cross-section.

Fig. 6 is a schematic representation of flow paths through a metal face seal gasket connection without an adapter and a metal face seal gasket connection using an adapter, shown in cross-section.

### Detailed Description of the Invention

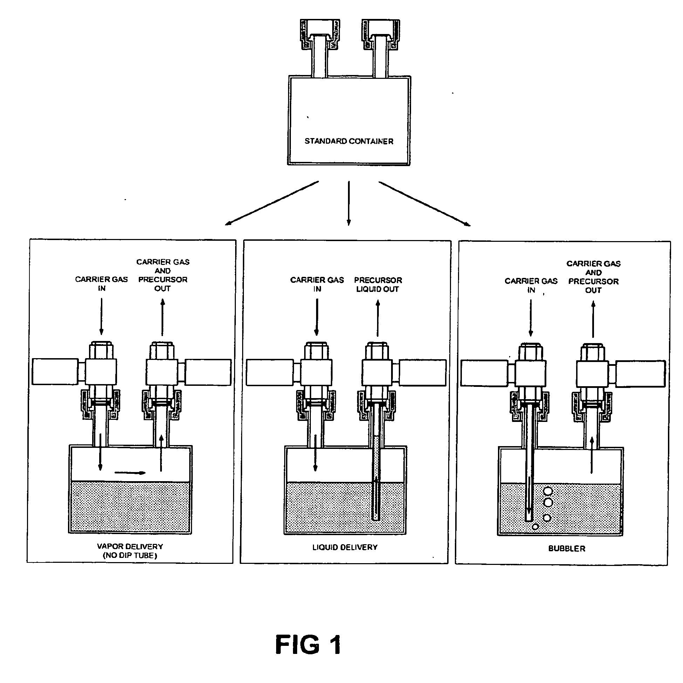

This invention reduces the number of container designs required to support different applications. A standard two port container without a tube can be converted to a container capable of being used in applications which require a tube (i.e., bubbler tube for gas delivery or a dip tube for liquid delivery), by inserting a gasket/tube adapter between one of the ports and the corresponding valve (see Fig. 1). The overall height of the container does not change. In contrast to prior art, the tube is not welded to the top of the container, so it can be removed if modification and/or replacement is necessary. This results in increased flexibility.

The practice of this invention does not increase the length required to add a tube to a contained using a face seal port (i.e., the gasket is already being used to seal the connection). Adding a tube to a port that uses a face seal fitting can be accomplished using an adapter with a compression fitting. The tube is inserted through the compression fitting to the desired length and then the compression fitting is secured on the tube. In terms of leak tightness, compression fittings are generally less desirable than joining two components with a face seal (removable) or by welding (not removable). Adding a tube to a port that uses a face seal fitting can be accomplished by using an opposing face seal component that has a tube welded to it, that is the opposite gender (male or female) as the port. From an overhead standpoint, this invention is better than welding a tube to a fitting, because it is universal (i.e., the gasket/tube adapter will work with face seal ports that are either male of female).

This invention simplifies the addition of a tube by allowing the use of standard set of gasket/tube adapters. Modification of the gasket/tube adapter can be done without exposing the container to contamination associated with the modification process (e.g., particles from machining or welding). The length of the tube can easily be changed by cutting it shorter or extending it. The gasket/tube adapter can be leak checked independently from the container. A leak at the seam of a dip tube welded directly to a container will cost more to correct, compared to a gasket/tube adapter (i.e., value of the ampoule is significantly higher than the gasket/tube adapter).

Various modifications and variations of this invention include the use of different materials of construction for the ampoules and adapters (e.g., copper, stainless steel, aluminum, nickel, Teflon, etc.); the use of different methods to join the gasket to the tube in forming the adapter (e.g., welding, machining, shrink fitting, etc.); the use of different face seal gasket styles (e.g., flat or contoured) and manufacturers (e.g., Parker, Hy-Tech, Swagelok, Fujikin, etc.); the use of different size gaskets and tubes (e.g., 3.18 mm (1/8 inch), 6.35 mm (¼ inch), 12.7 mm (½ inch), etc.); the length of tube can be varied; the tube can optionally have holes along the length; and the tube may be modified along its length (i.e., non uniform cross-section).

Fig. 1 shows , a vapor phase reagent dispensing apparatus which can be used with the methods of the present invention, the apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having a carrier gas feed inlet fitting connected thereto;

an adapter comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the first face seal port opening and an outlet end adjacent to the bottom wall member;

said first face seal port opening and said carrier gas feed inlet fitting having opposing surfaces, wherein the opposing surfaces are not in contact with one another;

said metal face seal gasket being aligned and in contact with the opposing surfaces of said first face seal port opening and said carrier gas feed inlet fitting;

fastening means for securing the carrier gas feed inlet fitting to said first face seal port opening through the opposing surfaces and said metal face seal gasket; and

said second face seal port opening having a vapor phase reagent outlet fitting connected thereto, through which said vapor phase reagent can be dispensed from said apparatus.

The vapor phase reagent dispensing apparatus further comprises a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and a vapor phase reagent discharge line extending exteriorly from the vapor phase reagent outlet fitting for removal of vapor phase reagent from said inner gas volume above the fill level, the vapor phase reagent discharge line optionally containing one or more vapor phase reagent flow control valves therein for control of flow of the vapor phase reagent therethrough.

The vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

Fig. 1 shows, a liquid phase reagent dispensing apparatus which can be used with the methods of the present invention, the apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having an inert gas feed inlet fitting connected thereto, through which an inert gas can be fed into the inner gas volume above the fill level to pressurize the inner gas volume above the fill level;

said second face seal port opening having a liquid phase reagent outlet fitting connected thereto;

an adapter comprising a metal face seal gasket joined to a tube that extends through the second face seal port opening and the inner gas volume into the source chemical and through which liquid phase reagent can be dispensed from said apparatus, said tube having an outlet end adjacent to the second face seal port opening and an inlet end adjacent to the bottom wall member;

said second face seal port opening and said liquid phase reagent outlet fitting having opposing surfaces, wherein the opposing surfaces are not in contact with one another;

said metal face seal gasket being aligned and in contact with the opposing surfaces of said second face seal port opening and said liquid phase reagent outlet fitting; and

fastening means for securing the liquid phase reagent outlet fitting to said second face seal port opening through the opposing surfaces and said metal face seal gasket.

The liquid phase reagent dispensing apparatus further comprises an inert gas feed line extending exteriorly from the inert gas feed inlet fitting for delivery of inert gas into said inner gas volume above the fill level, the inert gas feed line containing one or more inert gas flow control valves therein for control of flow of the inert gas therethrough; and a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough.

The liquid phase reagent dispensing apparatus further comprises the liquid phase reagent discharge line in liquid phase reagent flow communication with a vaporization apparatus, said vaporization apparatus in vapor phase reagent flow communication with a vapor phase delivery deposition system, said deposition system selected from a chemical vapor deposition system and an atomic layer deposition system.

The vessel or ampoule is typically machined from stainless steel, e.g., 316L, and electropolished to prevent contamination of the precursor liquid or solid source chemical. The adapter is also typically machined from stainless steel. The cover or top wall member is optionally removable to facilitate cleaning and reuse. The vessel can comprise a cylindrically shaped side wall member or side wall members defining a non-cylindrical shape.

Fastening means are used to secure the carrier gas feed inlet fitting to the first face seal port opening through the opposing surfaces and the metal face seal gasket of the adapter. Suitable fastening means include, for example, engagement of a male nut or body hex with a female nut.

Fastening means are used to secure the liquid phase reagent outlet fitting to the second face seal port opening through the opposing surfaces and the metal face seal gasket of the adapter. Suitable fastening means include, for example, engagement of a male nut or body hex with a female nut.

The gasket/tube assembly (i.e., adapter) would affect the flow pattern of fluid through the associated container and/or plumbing. The ability to redirect the flow pattern of a gas or liquid has uses in the delivery of precursors for depositing thin-films. The containers must be fabricated using a material that does not react with the precursor. As indicated above, stainless steel is commonly selected as the material for constructing the precursor container. The gasket tube assembly would be composed of a similar material (e.g., stainless steel or nickel).

The flow pattern of reactants (vapor phase and/or liquid phase) can also be redirected into a reaction vessel. An example of this utility is the co-injection of reactants used for thin-film deposition. Separation of reactants that are susceptible to vapor-phase reactions, until just prior to contacting the substrate surface, can decrease the likelihood of particle formation and increase film deposition rate.

The gasket/tube adapter may be prefabricated and inserted into the desired port. The face seal connection would then be sealed in the usual manner (e.g., by tightening the connection using the male and female nuts). An example of a face seal connection is VCR components (e.g., Swagelok), but other types could be used.

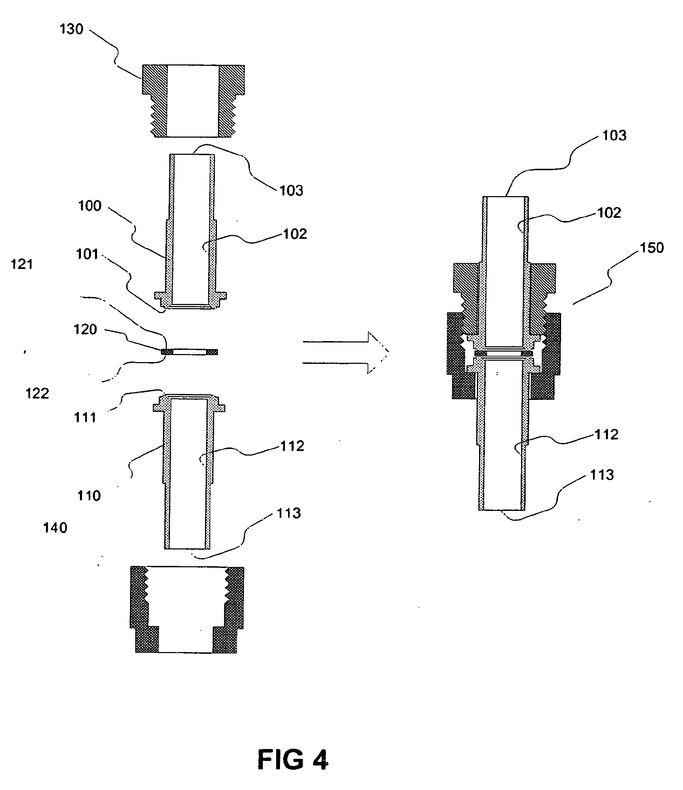

As indicated above, Fig. 4 is a cross-sectional view of components that can be used to assemble a metal gasket face seal connection 150 without a gasket/tube assembly (see Swagelok catalog MS-01-24). Metal gasket 120 is used in sealing face fittings (e.g., VCR from Swagelok). It is a disk with a hole in the center. 121 is the surface of metal gasket 120 that contacts bead 101 of face seal fitting 100 upon sealing. 122 is the surface of metal gasket 120 that contacts bead 111 of face seal fitting 110 upon sealing. 100 is a face seal fitting (e.g., VCR from Swagelok) that uses metal gasket 120 to connect to face seal fitting 110. 101 is the bead that forms the sealing surface of face seal fitting 100 with surface 121 of metal gasket 120. 102 is the internal surface of face seal fitting 100 in contact with the process fluid (liquid or gas). 103 is the end of face seal fitting 100, opposite the sealing bead 101. The end (103) of face seal fitting 100 is joined (e.g., welded) to the other process components (e.g., tubing, valves, vessels, etc.). Depending on the pressure gradient, fluid either enters or exits face seal fitting 100 through end 103.

Face seal fitting 110 uses metal gasket 120 to connect to face seal fitting 100. Bead 111 forms the sealing surface of face seal fitting 110 with surface 122 of metal gasket 120. 112 is the internal surface of face seal fitting 110 in contact with the process fluid (liquid or gas). 113 is the end of face seal fitting 110, opposite the sealing bead 111. The end (113) of face seal fitting 110 is joined (e.g., welded) to the other process components (e.g., tubing, valves, vessels, etc.). Depending on the pressure gradient, fluid either enters or exits face seal fitting 110 through end 113. Male nut 130 is tightened against the female nut 140 to form the assembled connection 150.

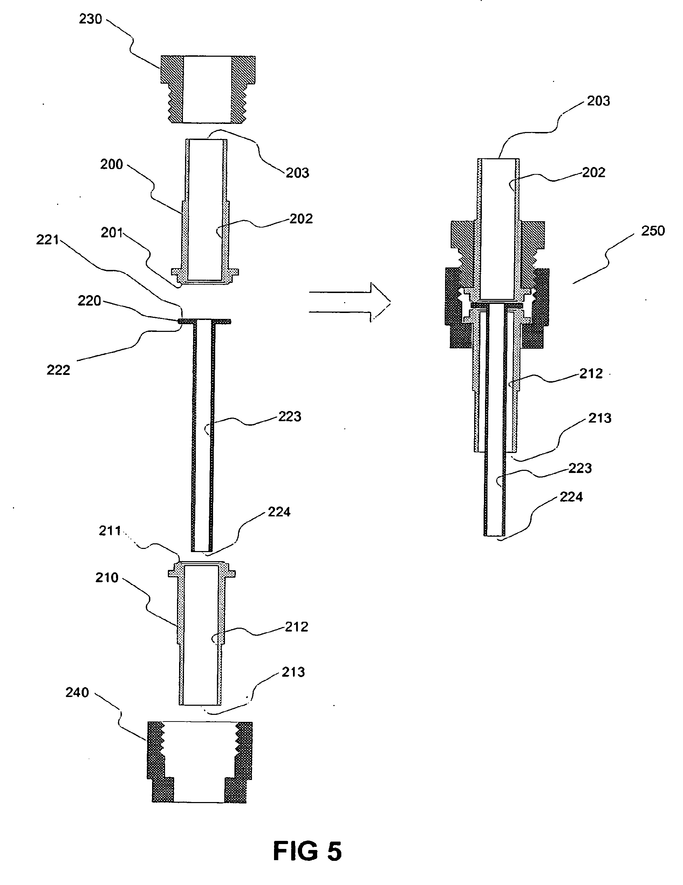

As indicated above, Fig. 5 is a cross-sectional view of components that can be used to assemble a metal gasket face seal connection using a gasket/tube adapter used in this invention. Metal gasket/tube adapter 220 consists of a metal gasket that has been joined to a tube. 221 is the surface of gasket/tube adapter 220 that contacts bead 201 of face seal fitting 200 upon sealing. 222 is the surface of gasket/tube adapter 220 that contacts bead 211 of face seal fitting 210 upon sealing. 223 is the internal surface of gasket/tube adapter 220 in contact with the process fluid (liquid or gas). 224 is the end of the gasket/tube adapter 220, opposite the end where surfaces 221 and 222 contact beads 201 and 211 respectively. Face seal fitting 200 (e.g., VCR from Swagelok) uses metal gasket/tube adapter 220 to connect to face seal fitting 210. Bead 201 forms the sealing surface of face seal fitting 200 with surface 221 of gasket/tube adapter 220. 202 is the internal surface of face seal fitting 200 in contact with the process fluid (liquid or gas).

203 is the end of face seal fitting 200, opposite the sealing bead 201. The end (203) of face seal fitting 200 is joined (e.g., welded) to the other process components (e.g., tubing, valves, vessels, etc.). Depending on the pressure grading fluid either enters or exits face seal fitting 200 through end 203.

Face seal fitting 210 uses metal gasket/tube adapter 220 to connect to face seal fitting 200. Bead 211 forms the sealing surface of face seal fitting 210 with surface 222 of gasket/tube adapter 220. 212 is the internal surface of face seal fitting 200 in contact with the process fluid (liquid or gas). 213 is the end of face seal fitting 210, opposite the sealing bead 211. The end (213) of face seal fitting 210 is joined (e.g., welded) to the other process components (e.g., tubing, valves, vessels, etc.). Because the connection was made using gasket/tube adapter 220, fluid does not flow through end 213. Instead, fluid flow proceeds through the end 224 of gasket/tube adapter 220. Male nut 230 is tightened against the female nut 240 to form the assembled connection 250. Upon assembling connection 250, no fluid flow takes place through end 213 of face seal fitting 210. Fluid entering or exiting face seal fitting 200 through end 203 either enters or exits the gasket/tube adapter 220 through end 224.

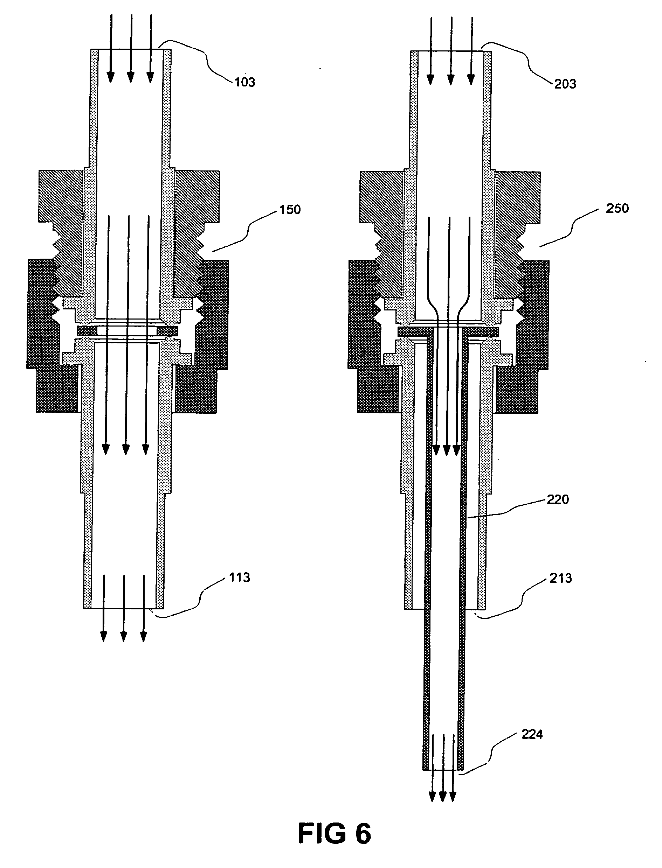

Fig. 6 shows an example of the flow paths through assemblies 150 and 250. The arrows in Fig. 6 indicate the direction and path of fluid flow. Due to the use of the gasket/tube adapter 220 in assembly 250, the path of fluid flow in assembly 250 is different than assembly 150.

The ampoule can include inlet and outlet valves to allow the chemicals to be delivered to the end use equipment. Optional ampoule equipment include a fill port and a source chemical level sensor to determine when the ampoule is nearly empty. The material in the container is delivered either under vacuum, for low vapor pressure chemicals, or using an inert gas to sweep the vapors out. The material may alternatively be delivered as a liquid through a dip tube to the end use equipment where it can be vaporized or dispensed as needed.

A temperature sensor is preferably included in the ampoule to ensure uniform heat conduction. A source chemical level sensor is preferably included in the ampoule to ensure efficient use of the source chemical. The valves and source chemical level sensor are attached via face seal connections to ensure a clean, leak proof seal. Once assembled in a clean room, the ampoule is conditioned to remove adsorbed water and leak checked with a helium leak detector. The ampoule is designed to be used at pressures from a few torr to slightly above ambient.

In an embodiment of this invention, the temperature sensor extends from an upper end exterior of the vessel through a portion of the top wall member and generally vertically downwardly into the interior volume of the vessel, with the lower end of the temperature sensor being located in non-interfering proximity to the surface of the bottom wall. The source chemical level sensor extends from an upper end exterior of the vessel through a portion of the top wall member and generally vertically downwardly into the interior volume of the vessel, with the lower end of the source chemical level sensor being located in non-interfering proximity to the surface of the bottom wall. The temperature sensor is operatively arranged in the vessel to determine the temperature of source chemical in the vessel, the source chemical level sensor is operatively arranged in the vessel to determine the level of source chemical in the vessel, the temperature sensor and source chemical level sensor are located in non-interfering proximity to each other in the vessel, with the lower end of the temperature sensor being located at the same or closer proximity to the surface of the vessel in relation to the lower end of the source chemical level sensor, and the temperature sensor and source chemical level sensor are in source chemical flow communication in the vessel. The source chemical level sensor is selected from ultrasonic sensors, optical sensors, capacitive sensors and float-type sensors, and said temperature sensor comprises a thermowell and thermocouple.

In an embodiment of this invention, the bottom wall member provides a sump cavity in which the lower end of a temperature sensor, source chemical level sensor, dip tube and/or bubbler tube may be disposed. Such a configuration can permit a high percentage, e.g., 95% or greater, preferably 98% or greater, of the volume of the originally furnished liquid or solid source chemical to be utilized in the application for which the source chemical is selectively dispensed. This configuration can also improve the economics of the source chemical supply and dispensing system and processes in which the dispensed source chemical is employed.

This invention allows for a minimal amount of semiconductor precursor chemical to remain in the ampoule or bubbler when the source chemical level sensor has signaled the end of the contents. This is very important as the complexity and cost of semiconductor precursors rises. In order to minimize costs, semiconductor manufacturers will want to waste as little precursor as possible. In addition, this invention places the temperature sensor in the same recessed sump cavity as the source chemical level sensor. This ensures that the true temperature of the source chemical semiconductor precursor will be read as long as the source chemical level sensor indicates there is precursor present. This is important from a safety standpoint. If the temperature sensor was to be outside of the semiconductor precursor it would send a false low temperature signal to the heating apparatus. This could lead to the application of excessive heat to the ampoule which can cause an unsafe situation and decomposition of the semiconductor precursor.

Referring again to the vessel or ampoule, the vessel can be equipped with a source chemical level sensor which extends from an upper portion exterior of the vessel, downwardly through a non-centrally located portion of the top wall member of the vessel, to a lower end, non-centrally located on the bottom floor member, in close proximity to the surface of the sump cavity of the vessel to permit utilization of at least 95% of source chemical reagent when source chemical reagent is contained in the vessel. The upper portion of the source chemical level sensor may be connected by a source chemical level sensing signal transmission line to a central processing unit, for transmission of sensed source chemical level signals from the source chemical level sensor to the central processing unit during operation of the system.

In a like manner, the vessel can be equipped with a temperature sensor, i.e., a thermowell and thermocouple, which extends from an upper portion exterior of the vessel, downwardly through a centrally located portion of the top wall member of the vessel, to a lower end, centrally located on the bottom wall member, in close proximity to the surface of the sump cavity of the vessel. The upper portion of the temperature sensor may be connected by a temperature sending signal transmission line to a central processing unit, for transmission of sensed temperature signals from the temperature sensor to the central processing unit during operation of the system.

The central processing unit, which may comprise a suitable microprocessor, computer, or other appropriate control means, may also be joined by a control signal transmission line to a flow control valve (e.g., via a suitable valve actuator element) to selectively adjust flow control valve and control the flow of carrier gas to the vessel. The central processing unit may also be joined by a control signal transmission line to a second flow control valve (e.g., via a suitable valve actuator element) to selectively adjust the flow control valve and control the discharge of vapor or liquid phase reagent from the vessel. For purposes of this invention, flow control valves shall include isolation valves, metering valves and the like.

This invention allows the semiconductor manufacturer to use the maximum amount of precursor while wasting very little before change-out of the ampoule. This minimizes waste and maximizes the return on the investment in the semiconductor precursor and specific application.

The source chemicals useful in this invention can vary over a wide range and include, for example, liquid or solid precursors for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table. Illustrative source chemicals include, for example, liquid or solid precursors for a metal selected from ruthenium, hafnium, tantalum, molybdenum, platinum, gold, titanium, lead, palladium, zirconium, bismuth, strontium, barium, calcium, antimony and thallium, or precursor for a metalloid selected from silicon, germanium and tellurium. Preferred organometallic precursor compounds include ruthenium-containing, hafnium-containing, tantalum-containing and/or molybdenum-containing organometallic precursor compounds.

Solid source chemicals that sublime and solid source chemicals that melt upon heating can be used in this invention. For example, solid source chemicals that sublime can be used in the vapor phase reagent dispensing apparatus shown in Fig. 1. Solid source chemicals that melt upon heating can be used in the vapor phase reagent dispensing apparatus shown in Fig. 1 and the liquid phase reagent dispensing apparatus shown in Fig. 1. Likewise, liquid source chemicals can be used in the vapor phase reagent dispensing apparatus shown in Fig. 1 and the liquid phase reagent dispensing apparatus shown in Fig. 1. When using solid source chemicals that sublime, it may be necessary to employ dust entrapment equipment.

The vapor or liquid phase reagents useful in this invention can vary over a wide range and include, for example, liquid or solid precursors for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table. Illustrative precursors include, for example, precursors for a metal selected from ruthenium, hafnium, tantalum, molybdenum, platinum, gold, titanium, lead, palladium, zirconium, bismuth, strontium, barium, calcium, antimony and thallium, or precursor for a metalloid selected from silicon, germanium and tellurium. Preferred organometallic precursor compounds include ruthenium-containing, hafnium-containing, tantalum-containing and/or molybdenum-containing organometallic precursor compounds.

The vapor phase reagent dispensing apparatus can further comprise a carrier gas source coupled to the carrier gas feed line. Likewise, the liquid phase reagent dispensing apparatus can further comprise an inert gas source coupled to the inert gas feed line.

The vapor phase reagent dispensing apparatus can further comprise:

a deposition chamber selected from a chemical vapor deposition chamber or an atomic layer deposition chamber;

the vapor phase reagent discharge line connecting the vapor phase reagent dispensing apparatus to the deposition chamber;

optionally a heatable susceptor contained within the deposition chamber and located in a receiving relationship to the vapor phase reagent discharge line; and

an effluent discharge line connected to the deposition chamber;

such that vapor phase reagent passes through the vapor phase reagent discharge line and into the deposition chamber, for contact with a substrate, optionally on the heatable susceptor, and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

The liquid phase reagent dispensing apparatus can further comprise:

a deposition chamber selected from a chemical vapor deposition chamber and an atomic layer deposition chamber;

the liquid phase reagent discharge line connecting the liquid phase reagent dispensing apparatus to a vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing a carrier gas flow control valve therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line containing a vapor phase reagent flow control valve therein for control of flow of the vapor phase reagent therethrough;

optionally a heatable susceptor contained within the deposition chamber and located in a receiving relationship to the vaporization apparatus; and

an effluent discharge line connected to the deposition chamber;

such that vapor phase reagent passes through the vapor phase reagent discharge line and into the deposition chamber, for contact with a substrate, optionally on the heatable susceptor, and any remaining effluent is discharged through the effluent discharge line.

The substrate can be comprised of a material selected from a metal, a metal silicide, a metal carbide, a metal nitride, a semiconductor, an insulator and a barrier material. The substrate is preferably a patterned wafer.

A vapor phase reagent dispensing apparatus which may be used with the invention may comprise:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, a carrier gas feed inlet opening and a vapor phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the carrier gas feed inlet opening, the face seal opening, the face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the carrier gas feed inlet opening and an outlet end adjacent to the bottom wall member;

said carrier gas feed inlet opening having a carrier gas feed inlet fitting attached thereto;

said carrier gas feed inlet opening and said carrier gas feed inlet fitting having opposing surfaces, wherein the opposing surfaces are not in contact with one another;

said metal face seal gasket being aligned and in contact with the opposing surfaces of said carrier gas feed inlet opening and said carrier gas feed inlet fitting;

fastening means for securing the carrier gas feed inlet fitting to said carrier gas feed inlet opening through the opposing surfaces and said metal face seal gasket; and

annular space between the outer wall of said tube and the inner walls of said carrier gas feed inlet opening, said face seal opening and said face seal port opening, through which said vapor phase reagent can be dispensed from said apparatus through said vapor phase reagent outlet opening.

The vapor phase reagent dispensing apparatus further comprises a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and a vapor phase reagent discharge line extending exteriorly from the vapor phase reagent outlet opening for removal of vapor phase reagent from said inner gas volume above the fill level, the vapor phase reagent discharge line optionally containing one or more vapor phase reagent flow control valves therein for control of flow of the vapor phase reagent therethrough.

The vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

The vapor phase reagent dispensing apparatus further comprises:

a deposition chamber selected from a chemical vapor deposition chamber or an atomic layer deposition chamber;

the vapor phase reagent discharge line connecting the vapor phase reagent dispensing apparatus to the deposition chamber;

optionally a heatable susceptor contained within the deposition chamber and located in a receiving relationship to the vapor phase reagent discharge line; and

an effluent discharge line connected to the deposition chamber;

such that vapor phase reagent passes through the vapor phase reagent discharge line and into the deposition chamber, for contact with a substrate, optionally on the heatable susceptor, and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

An example of a liquid phase reagent dispensing apparatus which may be used with invention may comprise:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, an inert gas feed inlet opening and a liquid phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the liquid phase reagent outlet opening, the face seal opening, the face seal port opening and the inner gas volume into the source chemical and through which liquid phase reagent can be dispensed from said apparatus, said tube having an outlet end adjacent to the liquid phase reagent outlet opening and an inlet end adjacent to the bottom wall member;

said liquid phase reagent outlet opening having a liquid phase reagent outlet fitting connected thereto;

said liquid phase reagent outlet opening and said liquid phase reagent outlet fitting having opposing surfaces, wherein the opposing surfaces are not in contact with one another;

said metal face seal gasket being aligned and in contact with the opposing surfaces of said liquid phase reagent outlet opening and said liquid phase reagent outlet fitting;

fastening means for securing the liquid phase reagent outlet fitting to said liquid phase reagent outlet opening through the opposing surfaces and said metal face seal gasket; and

annular space between the outer wall of said tube and the inner walls of said liquid phase reagent outlet opening, said face seal opening and said face seal port opening, through which an inert gas can be fed through the inert gas feed inlet opening into the inner gas volume above the fill level to pressurize the inner gas volume above the fill level.

The liquid phase reagent dispensing apparatus further may comprises an inert gas feed line extending exteriorly from the inert gas feed inlet opening for delivery of inert gas into said inner gas volume above the fill level, the inert gas feed line containing one or more inert gas flow control valves therein for control of flow of the inert gas therethrough; and a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough.

The liquid phase reagent dispensing apparatus further may comprises the liquid phase reagent discharge line in liquid phase reagent flow communication with a vaporization apparatus, said vaporization apparatus in vapor phase reagent flow communication with a vapor phase delivery deposition system, said deposition system selected from a chemical vapor deposition system and an atomic layer deposition system.

The liquid phase reagent dispensing apparatus further may comprises:

a deposition chamber selected from a chemical vapor deposition chamber and an atomic layer deposition chamber;

the liquid phase reagent discharge line connecting the liquid phase reagent dispensing apparatus to a vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing a carrier gas flow control valve therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line containing a vapor phase reagent flow control valve therein for control of flow of the vapor phase reagent therethrough;

a heatable susceptor contained within the deposition chamber and located in a receiving relationship to the vaporization apparatus; and

an effluent discharge line connected to the deposition chamber;

such that vapor phase reagent passes through the vapor phase reagent discharge line and into the deposition chamber, for contact with a substrate on the heatable susceptor and any remaining effluent is discharged through the effluent discharge line.

The substrate is comprised of a material selected from a metal, a metal silicide, a metal carbide, a metal nitride, a semiconductor, an insulator and a barrier material. The substrate is preferably a patterned wafer.

As indicated above, this invention relates to a method for delivery of a vapor phase reagent to a deposition chamber comprising:

providing a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having a carrier gas feed inlet fitting connected thereto;

an adapter comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the first face seal port opening and an outlet end adjacent to the bottom wall member;

said first face seal port opening and said carrier gas feed inlet fitting having opposing surfaces, wherein the opposing surfaces are not in contact with one another;

said metal face seal gasket being aligned and in contact with the opposing surfaces of said first face seal port opening and said carrier gas feed inlet fitting;

fastening means for securing the carrier gas feed inlet fitting to said first face seal port opening through the opposing surfaces and said metal face seal gasket;

a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough;

said second face seal port opening having a vapor phase reagent outlet fitting connected thereto, through which said vapor phase reagent can be dispensed from said apparatus; and

a vapor phase reagent discharge line extending and exteriorly from the vapor phase reagent outlet fitting for removal of vapor phase reagent from said inner gas volume above the fill level, the vapor phase reagent discharge line optionally containing one or more vapor phase reagent flow control valves therein for control of flow of the vapor phase reagent therethrough;

adding source chemical to said vapor phase reagent dispensing apparatus;

heating the source chemical in said vapor phase reagent dispensing apparatus to a temperature sufficient to vaporize the source chemical to provide vapor phase reagent;

feeding a carrier gas into said vapor phase reagent dispensing apparatus through said carrier gas feed line and said tube;

withdrawing the vapor phase reagent and carrier gas from said vapor phase reagent dispensing apparatus through said vapor phase reagent discharge line; and

feeding the vapor phase reagent and carrier gas into said deposition chamber.

The method can further comprise:

contacting the vapor phase reagent with a substrate, optionally on a heatable susceptor, within the deposition chamber; and

discharging any remaining effluent through an effluent discharge line connected to the deposition chamber. The deposition chamber can be selected from a chemical vapor deposition chamber and ain atomic layer deposition chamber.

In operation of the system described above, source chemical is placed in the vessel and heated to a temperature sufficient to vaporize the source chemical. Carrier gas is allowed to flow through the carrier gas feed line to the carrier gas feed inlet opening and through bubbler tube from which it is bubbled into the source chemical. A carrier gas flow control valve controls the flow of the carrier gas that is discharged into the source chemical. Vapor from the source chemical becomes entrained in the carrier gas to produce vapor phase reagent.

The vapor phase reagent is discharged from the inner gas volume through the vapor phase reagent outlet opening and the vapor phase reagent discharge line. The vapor phase reagent is flowed in the vapor phase reagent discharge line to the deposition chamber. A vapor phase reagent flow control valve controls the flow of the vapor phase reagent that is flowed to the deposition chamber. In the deposition chamber, the vapor phase reagent is deposited onto the wafer or other substrate element that is mounted on a heatable substrate or other mount structure. Effluent vapor from the deposition chamber is discharged in effluent discharge line. The effluent may be passed to recycle, recovery, waste treatment, disposal, or other disposition means.

During this operation, the source chemical fill level in the vessel is detected by a source chemical level sensor. It is important to know when the liquid precursor chemical inside of the vessel is close to running out so that it can be changed at the end of a chemical vapor deposition or atomic layer deposition cycle. The source chemical level progressively declines and eventually lowers into the sump cavity to a minimum liquid head (height of liquid in the sump cavity), at which point the central processing unit receives a corresponding sensed source chemical level signal by a source chemical level sensing signal transmission line. The central processing unit responsively transmits a control signal in a control signal transmission line to the carrier gas flow control valve to close the valve and shut off the flow of carrier gas to the vessel, and also concurrently transmits a control signal in a control signal transmission line to close the vapor phase reagent flow control valve, to shut off the flow of vapor phase reagent from the vessel.

Also, during this operation, the temperature of the source chemical in vessel is detected by a temperature sensor. It is important to monitor the temperature of the liquid precursor chemical inside af the vessel to control the vapor pressure. If the temperature of the source chemical in the vessel becomes too high, the central processing unit receives a corresponding sensed temperature signal by a temperature sensing signal transmission line. The central processing unit responsively transmits a control signal in a control signal transmission line to a heating means to decrease the temperature.

The vapor phase reagent dispensing apparatus, e.g., bubbler, which may be used with the methods of this invention may be useful for vaporization of liquids and solid materials, e.g., liquid and solid source reagents used in chemical vapor deposition, atomic layer deposition and ion implantation processes. See, for example, U.S. Patent 7,077,388 B2.

As indicated above, this invention relates in part to a method for delivery of a vapor phase reagent to a deposition chamber comprising:

providing a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a first face seal port opening, a second face seal port opening and optionally one or more other face seal port openings;

said first face seal port opening having an inert gas feed inlet fitting connected thereto, through which an inert gas can be fed into the inner gas volume above the fill level to pressurize the inner gas volume above the fill level;

said second face seal port opening having a liquid phase reagent outlet fitting connected thereto;

an adapter comprising a metal face seal gasket joined to a tube that extends through the second face seal port opening and the inner gas volume into the source chemical and through which liquid phase reagent can be dispensed from said apparatus, said tube having an outlet end adjacent to the second face seal port opening and an inlet end adjacent to the bottom wall member;

said second face seal port opening and said liquid phase reagent outlet fitting having opposing surfaces, wherein the opposing surfaces are not in contact with one another;

said metal face seal gasket being aligned and in contact with the opposing surfaces of said second face seal port opening and said liquid phase reagent outlet fitting;

fastening means for securing the liquid phase reagent outlet fitting to said second face seal port opening through the opposing surfaces and said metal face seal gasket;

an inert gas feed line extending exteriorly from the inert gas feed inlet fitting for delivery of inert gas into said inner gas volume above the fill level, the inert gas feed line containing one or more inert gas flow control valves therein for control of flow of the inert gas therethrough; and

a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough;

adding liquid phase reagent to said liquid phase reagent dispensing apparatus;

optionally heating a solid source chemical in said liquid phase reagent dispensing apparatus to a temperature sufficient to melt the solid source chemical to provide liquid phase reagent;

feeding an inert gas into said liquid phase reagent dispensing apparatus through said inert gas feed line;

withdrawing the liquid phase reagent from said liquid phase reagent dispensing apparatus through said tube and said liquid phase reagent discharge line;

providing a vaporization apparatus comprising:

a vessel configured to form an internal vessel compartment to vaporize the liquid phase reagent;

said liquid phase reagent discharge line connecting the liquid phase reagent dispensing apparatus to said vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing one or more carrier gas flow control valves therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line optionally containing one or more vapor phase reagent flow control valves therein for control of flow of the vapor phase reagent therethrough;

feeding the liquid phase reagent into said vaporization apparatus;

heating the liquid phase reagent in said vaporization apparatus to a temperature sufficient to vaporize the liquid phase reagent to provide said vapor phase reagent;

feeding a carrier gas into said vaporization apparatus through said carrier gas feed line;

withdrawing the vapor phase reagent and carrier gas from said vaporization apparatus through said vapor phase reagent discharge line; and

feeding the vapor phase reagent and carrier gas into said deposition chamber.

The method can further comprise:

contacting the vapor phase reagent with a substrate, optionally on a heatable susceptor, within the deposition chamber; and

discharging any remaining effluent through an effluent discharge line connected to the deposition chamber. The deposition chamber can be selected from a chemical vapor deposition chamber and an atomic layer deposition chamber.

In operation of the system described above, source chemical is placed in the vessel and an inert gas is allowed to flow through the inert gas feed line to the inert gas feed inlet opening and into the inner gas volume above the fill level to pressurize the inner gas volume above the fill level. An inert gas flow control valve controls the flow of the inert gas that is discharged into the inner gas volume above the fill level.

The liquid phase reagent is discharged from the vessel through liquid phase reagent outlet opening (e.g., dip tube) and the liquid phase reagent discharge line. The liquid phase reagent is flowed in the liquid phase reagent discharge line to the vaporization apparatus. A liquid phase reagent flow control valve controls the flow of the liquid phase reagent that is flowed to the vaporization apparatus.

In vaporization apparatus, the liquid phase reagent is vaporized to form a source vapor for the subsequent vapor deposition operation. The vaporization apparatus may also receive a carrier gas for combining with or shrouding the source vapor produced by vaporization of the liquid phase reagent. Alternatively, the source vapor may be passed to the downstream vapor deposition operation in neat form. In any event, the source vapor from vaporization apparatus is flowed through vapor phase reagent discharge line to deposition chamber. In the deposition chamber, the vapor phase reagent is deposited onto the wafer or other substrate element that is mounted on a heatable substrate or other mount structure. Effluent vapor from the deposition chamber is discharged in effluent discharge line. The effluent may be passed to recycle, recovery, waste treatment, disposal, or other disposition means.

During this operation, the source chemical fill level in the vessel is detected by a source chemical level sensor. It is important to know when the liquid precursor chemical inside of the vessel is close to running out so that it can be changed at the end of a chemical vapor deposition or atomic layer deposition cycle. The source chemical level progressively declines and eventually lowers into the sump cavity to a minimum liquid head (height of liquid in the sump cavity), at which point the central processing unit receives a corresponding sensed source chemical level signal by a source chemical level sensing signal transmission line. The central processing unit responsively transmits a control signal in a control signal transmission line to the carrier gas flow control valve to close the valve and shut off the flow of carrier gas to the vessel, and also concurrently transmits a control signal in a control signal transmission line to close the liquid phase reagent flow control valve, to shut off the flow of liquid reagent from the vessel.

Also, during this operation, the temperature of the source chemical in vessel is detected by a temperature sensor. It is important to monitor the temperature of the liquid precursor chemical inside of the vessel to control the vapor pressure. If the temperature of the source chemical in the vessel becomes too high, the central processing unit receives a corresponding sensed temperature signal by a temperature sensing signal transmission line. The central processing unit responsively transmits a control signal in a control signal transmission line to a heating means to decrease the temperature.

The liquid phase reagent dispensing apparatus which may be used in the methods of this invention may be useful for dispensing of reagents such as precursors used in chemical vapor deposition, atomic layer deposition and ion implantation processes, and can achieve a high level of withdrawal of liquid reagent from the vessel. See, for example, U.S. Patent 6,077,356.

In another embodiment, this invention relates in part to a method for delivery of a vapor phase reagent to a deposition chamber comprising:

providing a vapor phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port openings;

a face seal tee fitting having a face seal opening, a carrier gas feed inlet opening and a vapor phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the carrier gas feed inlet opening, the face seal opening, the face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end adjacent to the carrier gas feed inlet opening and an outlet end adjacent to the bottom wall member;

said carrier gas feed inlet opening having a carrier gas feed inlet fitting attached thereto;

said carrier gas feed inlet opening and said carrier gas feed inlet fitting having opposing surfaces, wherein the opposing surfaces are not in contact with one another;

said metal face seal gasket being aligned and in contact with the opposing surfaces of said carrier gas feed inlet opening and said carrier gas feed inlet fitting;

fastening means for securing the carrier gas feed inlet fitting to said carrier gas feed inlet opening through the opposing surfaces and said metal face seal gasket;

annular space between the outer wall of said tube and the inner walls of said carrier gas feed inlet opening, said face seal opening and said face seal port opening, through which said vapor phase reagent can be dispensed from said apparatus through said vapor phase reagent outlet opening;

a carrier gas feed line extending exteriorly from the carrier gas feed inlet fitting for delivery of carrier gas into said source chemical, the carrier gas feed line containing one or more carrier gas flow control valves therein for control of flow of the carrier gas therethrough; and

a vapor phase reagent discharge line extending exteriorly from the vapor phase reagent outlet opening for removal of vapor phase reagent from said inner gas volume above the fill level, the vapor phase reagent discharge line optionally containing one or more vapor phase reagent flow control valves therein for control of flow of the vapor phase reagent therethrough;

adding source chemical to said vapor phase reagent dispensing apparatus;

heating the source chemical in said vapor phase reagent dispensing apparatus to a temperature sufficient to vaporize the source chemical to provide vapor phase reagent;

feeding a carrier gas into said vapor phase reagent dispensing apparatus through said carrier gas feed line and said tube;

withdrawing the vapor phase reagent and carrier gas from said vapor phase reagent dispensing apparatus through said vapor phase reagent discharge line; and

feeding the vapor phase reagent and carrier gas into said deposition chamber.

The method further comprises:

contacting the vapor phase reagent with a substrate, optionally on a heatable susceptor, within the deposition chamber; and

discharging any remaining effluent through an effluent discharge line connected to the deposition chamber.

In the above method, the vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

In another embodiment, this invention relates in part to a method for delivery of a vapor phase reagent to a deposition chamber comprising:

providing a liquid phase reagent dispensing apparatus comprising:

a vessel which comprises a top wall member, a side wall member and a bottom wall member configured to form an internal vessel compartment to hold a source chemical up to a fill level and to additionally define an inner gas volume above the fill level;

said top wall member having a face seal port opening and optionally one or more other face seal port opening;

a face seal tee fitting having a face seal opening, an inert gas feed inlet opening and a liquid phase reagent outlet opening;

said face seal port opening having said face seal tee fitting connected thereto through the face seal opening, said face seal port opening and said face seal opening having opposing surfaces, wherein the opposing surfaces are not in contact with one another;

a face seal gasket, e.g., metal, being aligned and in contact with the opposing surfaces of said face seal port opening and said face seal opening;

fastening means for securing the face seal tee fitting to said face seal port opening through the opposing surfaces and said face seal gasket;

an adapter comprising a metal face seal gasket joined to a tube that extends through the liquid phase reagent outlet opening, the face seal opening, the face seal port opening and the inner gas volume into the source chemical and through which liquid phase reagent can be dispensed from said apparatus, said tube having an outlet end adjacent to the liquid phase reagent outlet opening and an inlet end adjacent to the bottom wall member;

said liquid phase reagent outlet opening having a liquid phase reagent outlet fitting connected thereto;

said liquid phase reagent outlet opening and said liquid phase reagent outlet fitting having opposing surfaces, therein the opposing surfaces are not in contact with one another;

said metal face seal gasket being aligned and in contact with the opposing surfaces of said liquid phase reagent outlet opening and said liquid phase reagent outlet fitting;

fastening means for securing the liquid phase reagent outlet fitting to said liquid phase reagent outlet opening through the opposing surfaces and said metal face seal gasket;

annular space between the outer wall of said tube and the inner walls of said liquid phase reagent outlet opening, said face seal opening and said face seal port opening, through which an inert gas can be fed through the inert gas feed inlet opening into the inner gas volume above the fill level to pressurize the inner gas volume above the fill level;

an inert gas feed line extending exteriorly from the inert gas feed inlet opening for delivery of inert gas into said inner gas volume above the fill level, the inert gas feed line containing one or more inert gas flow control valves therein for control of flow of the inert gas therethrough; and

a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough;

adding liquid phase reagent to said liquid phase reagent dispensing apparatus;

optionally heating a solid source chemical in said liquid phase reagent dispensing apparatus to a temperature sufficient to melt the solid source chemical to provide liquid phase reagent;

feeding an inert gas into said liquid phase reagent dispensing apparatus through said inert gas feed line;

withdrawing the liquid phase reagent from said liquid phase reagent dispensing apparatus through said tube and said liquid phase reagent discharge line;

providing a vaporization apparatus comprising:

a vessel configured to form an internal vessel compartment to vaporize the liquid phase reagent;

said liquid phase reagent discharge line connecting the liquid phase reagent dispensing apparatus to said vaporization apparatus;

a portion of the vaporization apparatus having a carrier gas feed inlet opening through which carrier gas can be fed into said vaporization apparatus to cause vapor of said liquid phase reagent to become entrained in said carrier gas to produce vapor phase reagent;

a portion of the vaporization apparatus having a vapor phase reagent outlet opening through which said vapor phase reagent can be dispensed from said vaporization apparatus;

a carrier gas feed line extending from the carrier gas feed inlet opening exteriorly from the vaporization apparatus for delivery of carrier gas into said vaporization apparatus, the carrier gas feed line containing one or more carrier gas flow control valves therein for control of flow of the carrier gas therethrough;

a vapor phase reagent discharge line extending from the vapor phase reagent outlet opening exteriorly from the vaporization apparatus for removal of vapor phase reagent from said vaporization apparatus to said deposition chamber, the vapor phase reagent discharge line optionally containing one or more vapor phase reagent flow control valves therein for control of flow of the vapor phase reagent therethrough;

feeding the liquid phase reagent into said vaporization apparatus;

heating the liquid phase reagent in said vaporization apparatus to a temperature sufficient to vaporize the liquid phase reagent to provide said vapor phase reagent;

feeding a carrier gas into said vaporization apparatus through said carrier gas feed line;

withdrawing the vapor phase reagent and carrier gas from said vaporization apparatus through said vapor phase reagent discharge line; and

feeding the vapor phase reagent and carrier gas into said deposition chamber.

The method further comprises:

contacting the vapor phase reagent with a substrate, optionally on a heatable susceptor, within the deposition chamber; and

discharging any remaining effluent through an effluent discharge line connected to the deposition chamber.

In the method above, the liquid phase reagent dispensing apparatus further comprises the liquid phase reagent discharge line in liquid phase reagent flow communication with said vaporization apparatus, said vaporization apparatus in vapor phase reagent flow communication with a vapor phase delivery deposition system, said deposition system selected from a chemical vapor deposition system and an atomic layer deposition system.

In an embodiment of this invention, an organometallic compound is employed in vapor phase deposition techniques for forking powders, films or coatings. The compound can be employed as a single source precursor or can be used together with one or more other precursors, for instance, with vapor generated by heating at least one other organometallic compound or metal complex.

Deposition can be conducted in the presence of other vapor phase components. In an embodiment of the invention, film deposition is conducted in the presence of at least one non-reactive carrier gas. Examples of non-reactive gases include inert gases, e.g., nitrogen, argon, helium, as well as other gases that do not react with the organometallic compound precursor under process conditions. In other embodiments, film deposition is conducted in the presence of at least one reactive gas. Some of the reactive gases that can be employed include but are not limited to hydrazine, oxygen, hydrogen, air, oxygen-enriched air, ozone (O₃), nitrous oxide (N₂O), water vapor, organic vapors, ammonia and others. As known in the art, the presence of an oxidizing gas, such as, for example, air, oxygen, oxygen-enriched air, O₃, N₂O or a vapor of an oxidizing organic compound, favors the formation of a metal oxide film.

Deposition methods described herein can be conducted to form a film, powder or coating that includes a single metal or a films, powder or coating that includes a single metal oxide. Mixed films, powders or coatings also can be deposited, for instance mixed metal oxide films. A mixed metal oxide film can be formed, for example, by employing several organometallic precursors, at least one of which being selected from the organometallic compounds described above.

Vapor phase film deposition can be conducted to form film layers of a desired thickness, for example, in the range of from less than 1 nm to over 1 mm. The precursors described herein are particularly useful for producing thin films, e.g., films having a thickness in the range of from about 10 nm to about 100 nm. Films of this invention, for instance, can be considered for fabricating metal electrodes, in particular as n-channel metal electrodes in logic, as capacitor electrodes for DRAM applications, and as dielectric materials.

The deposition method also is suited for preparing layered films, wherein at least two of the layers differ in phase or composition. Examples of layered film include metal-insulator-semiconductor, and metal-insulator-metal.

The organometallic compound precursors can be employed in atomic layer deposition, chemical vapor deposition or, more specifically, in metalorganic chemical vapor deposition processes known in the art. For instance, the organometallic compound precursors described above can be used in atmospheric, as well as in low pressure, chemical vapor deposition processes. The compounds can be employed in hot wall chemical vapor deposition, a method in which the entire reaction chamber is heated, as well as in cold or warm wall type chemical vapor deposition, a technique in which only the substrate is being heated.

The organometallic compound precursors described above also can be used in plasma or photo-assisted chemical vapor deposition processes, in which the energy from a plasma or electromagnetic energy, respectively, is used to activate the chemical vapor deposition precursor. The compounds also can be employed in ion-beam, electron-beam assisted chemical vapor deposition processes in which, respectively, an ion beam or electron beam is directed to the substrate to supply energy for decomposing a chemical vapor deposition precursor. Laser-assisted chemical vapor deposition processes, in which laser light is directed to the substrate to affect photolytic reactions of the chemical vapor deposition precursor, also can be used.

The deposition method can be conducted in various chemical vapor deposition reactors, such as, for instance, hot or cold-wall reactors, plasma-assisted, beam-assisted or laser-assisted reactors, as known in the art.

Illustrative substrates useful in the deposition chamber include, for example, materials selected from a metal, a metal silicide, a semiconductor, an insulator and a barrier material. A preferred substrate is a patterned wafer. Examples of substrates that can be coated employing the deposition method include solid substrates such as metal substrates, e.g., Al, Ni, Ti, Co, Pt, Ta; metal silicides, e.g., TiSi₂, CoSi₂, NiSi₂; semiconductor materials, e.g., Si, SiGe, GaAs, InP, diamond, GaN, SiC; insulators, e.g., SiO₂, Si₃N₄. HfO₂, Ta₂O₅, Al₂O₃, barium strontium titanate (BST); barrier materials, e.g., TiN, TaN; or on substrates that include combinations of materials. In addition, films or coatings can be formed on glass, ceramics, plastics, thermoset polymeric materials, and on other coatings or film layers. In a preferred embodiment, film deposition is on a substrate used in the manufacture or processing of electronic components. In other embodiment, a substrate is employed to support a low resistivity conductor deposit that is stable in the presence of an oxidizer at high temperature or an optically transmitting film.

The deposition method can be conducted to deposit a film on a substrate that has a smooth, flat surface. In an embodiment, the method is conducted to deposit a film on a substrate used in wafer manufacturing or processing. For instance, the method can be conducted to deposit a film on patterned substrates that include features such as trenches, holes or vias. Furthermore, the deposition method also can be integrated with other steps in wafer manufacturing or processing, e.g., making, etching and others.

Chemical vapor deposition films can be deposited to a desired thickness. For example, films formed can be less than 1 micron thick, preferably less than 500 nanometers and more preferably less than 200 nanometers thick. Films that are less than 50 nanometers thick, for instance, films that have a thickness between about 0.1 and about 20 nanometers, also can be produced.

Organometallic compound precursors described above also can be employed in the method of the invention to form films by atomic layer deposition or atomic layer nucleation techniques, during which a substrate is exposed to alternate pulses of precursor, oxidizer and inert gas streams. Sequential layer deposition techniques are described, for example, in U.S. Patent No. 6,287,965 and in U.S. Patent No. 6,342,277. The disclosures of both patents are incorporated herein by reference in their entirety.

For example, in one atomic layer deposition cycle, a substrate is exposed, in step-wise manner, to: a) an inert gas; b) inert gas carrying precursor vapor; c) inert gas; and d) oxidizer, alone or together with inert gas. In general, each step can be as short as the equipment will permit (e.g. milliseconds) and as long as the process requires (e.g, several seconds or minutes). The duration of one cycle can be as short as milliseconds and as long as minutes. The cycle is repeated over a period that can range from a few minutes to hours. Film produced can be a few nanometers thin or thicker, e.g., 1 millimeter (mm).

The means and method of this invention thus achieves a substantial advance in the art, in the provision of a system for supply and dispensing of a vapor or liquid phase reagent, which permits 95-98% of the volume of the originally furnished source chemical to be utilized in the application for which the vapor or liquid phase reagent is selectively dispensed. The ease of cleaning of the two-part ampoule allows for re-use of these ampoules beyond what may be attained with the one-part ampoules.

Correspondingly, in operations such as the manufacture of semiconductor and superconductor products, it is possible with the means and method of this invention to reduce the waste of the source chemical to levels as low as 2-5% of the volume originally loaded into the dispensing vessel, and to re-use the ampoules many times over.

Accordingly, the practice of this invention markedly improves the economics of the source chemical supply and vapor or liquid phase reagent dispensing system, and the process in which the dispensed vapor or liquid phase reagent is employed. The invention in some instances may permit the cost-effective utilization of source chemicals which were as a practical matter precluded by the waste levels characteristic of prior art practice.

## Claims

1. A method for delivery of a vapor phase reagent to a deposition chamber comprising:
(a) providing a vapor phase reagent dispensing apparatus comprising:
a vessel which comprises a top wall member, a side wall member and a bottom wall member configured to form an internal vessel compartment to hold a source chemical up to a fill level and to additionally define an inner gas volume above the fill level;
said top wall member having a first face seal port opening (210), a second face seal port opening (110) and optionally one or more other face seal port openings;
said first face seal port opening having a carrier gas feed inlet fitting (200) connected thereto;
an adapter (220) comprising a metal face seal gasket joined to a tube that extends through the first face seal port opening and said inner gas volume into the source chemical and through which a carrier gas can be bubbled into the source chemical to cause at least a portion of source chemical vapor to become entrained in said carrier gas to produce a flow of vapor phase reagent to said inner gas volume above the fill level, said tube having an inlet end (221) adjacent to the first face seal port opening and an outlet end (224) adjacent to the bottom wall member;
said first face seal port opening and said carrier gas feed inlet fitting having opposing surfaces, wherein the opposing surfaces are not in contact with one another;
said metal face seal gasket being aligned and in contact with the opposing surfaces of said first face seal port opening and said carrier gas feed inlet fitting;
fastening means (230, 240) for securing the carrier gas feed inlet fitting to said first face seal port opening through the opposing surfaces and said metal face seal gasket;
a carrier gas feed line extending exteriorly from the carrier gas feed west fitting for delivery of carrier gas into said source chemical, the carrier gas feed line containing one or more carrier gas flow control valves therein for control of flow of the carrier gas therethrough;
said second face seal port opening having a vapor phase reagent outlet fitting (100) connected thereto, through which said vapor phase reagent can be dispensed from said apparatus; and
a vapor phase reagent discharge line extending exteriorly from the vapor phase reagent outlet fitting for removal of vapor phase reagent from said inner gas volume above the fill level, the vapor phase reagent discharge line optionally containing one or more vapor phase reagent flaw control valves therein for control of flow of the vapor phase reagent therethrough;
(b) adding source chemical to said vapor phase reagent dispensing apparatus;
(c) heating the source chemical in said vapor phase reagent dispensing apparatus to a temperature sufficient to vaporize the source chemical to provide vapor phase reagent;
(d) feeding a carrier gas into said vapor phase reagent dispensing apparatus through said carrier gas feed line and said tube;
(e) withdrawing the vapor phase reagent and carrier gas from said vapor phase reagent dispensing apparatus through said vapor phase reagent discharge line; and
(f) feeding the vapor phase reagent and carrier gas into said deposition chamber.

2. The method of claim 1 wherein the tube (220) comprises a bubbler tube and is made of stainless steel.

3. The method of claim 1 wherein the vapor phase reagent dispensing apparatus further comprises the vapor phase reagent discharge line in vapor phase reagent flow communication with a vapor phase delivery deposition system, said deposition system selected from a chemical vapor deposition system or an atomic layer deposition system.

4. A method for delivery of a vapor phase reagent to a deposition chamber comprising:
(a) providing a liquid phase reagent dispensing apparatus comprising:
a vessel which comprises a top wall member, a side wall member and a bottom wall member configured to form an internal vessel compartment to hold a source chemical up to a fill level and to additionally define an inner gas volume above the fill level;
said top wall member having a first face seal port opening (110), a second face seal port opening (210) and optionally one or more other face seal port openings;
said first face seal port opening having an inert gas feed inlet fitting (100) connected thereto, through which an inert gas can be fed into the inner gas volume above the fill level to pressurize the inner gas volume above the fill level;
said second face seal port opening having a liquid phase reagent outlet fitting (200) connected thereto;
an adapter (220) comprising a metal face seal gasket joined to a tube that extends through the second face seal port opening and the inner gas volume into the source chemical and through which liquid phase reagent can be dispensed from said apparatus, said tube having an outlet end (221) adjacent to the second face seal port opening and an inlet end (224) adjacent to the bottom wall member;
said second face seal port opening and said liquid phase reagent outlet fitting having opposing surfaces, wherein the opposing surfaces are not in contact with one another;
said metal face seal gasket being aligned and in contact with the opposing surfaces of said second face seal port opening and said liquid phase reagent outlet fitting;
fastening means (230, 240) for securing the liquid phase reagent outlet fitting to said second face seal port opening through the opposing surfaces and said metal face seal gasket;
an inert gas feed line extending exteriorly from the inert gas feed inlet fitting for delivery of inert gas into said inner gas volume above the fill level, the inert gas feed line containing one or more inert gas flow control valves therein for control of flow of the inert gas therethrough; and
a liquid phase reagent discharge line extending exteriorly from the liquid phase reagent outlet fitting for removal of liquid phase reagent from said vessel, the liquid phase reagent discharge line optionally containing one or more liquid phase reagent flow control valves therein for control of flow of the liquid phase reagent therethrough;
(b) adding liquid phase reagent to said liquid phase reagent dispensing apparatus;
(c) optionally heating a solid source chemical in said liquid phase reagent dispensing apparatus to a temperature sufficient to melt the solid source chemical to provide liquid phase reagent;
(d) feeding an inert gas into said liquid phase reagent dispensing apparatus through said inert gas feed line;
(e) withdrawing the liquid phase reagent from said liquid phase reagent dispensing apparatus through said tube and said liquid phase reagent discharge line;
(f) providing a vaporization apparatus comprising:
a vessel configured to form an internal vessel compartment to vaporize the liquid phase reagent;
said liquid phase reagent discharge line connecting the liquid phase reagent dispensing apparatus to said vaporization apparatus;
a portion of the vaporization apparatus having a carrier gas feed inlet opening through which carrier gas can be fed into said vaporization apparatus to cause vapor of said liquid phase reagent to become entrained in said carrier gas to produce vapor phase reagent;
a portion of the vaporization apparatus having a vapor phase reagent outlet opening through which said vapor phase reagent can be dispensed from said vaporization apparatus;
a carrier gas feed line extending from the carrier gas feed inlet opening exteriorly from the vaporization apparatus for delivery of carrier gas into said vaporization apparatus, the carrier gas feed line containing one or more carrier gas flow control valves therein for control of flow of the carrier gas therethrough;
a vapor phase reagent discharge line extending from the vapor phase reagent outlet opening exteriorly from the vaporization apparatus for removal of vapor phase reagent from said vaporization apparatus to said deposition chamber, the vapor phase reagent discharge line optionally containing one or more vapor phase reagent flow control valves therein for control of flow of the vapor phase reagent therethrough;
(g) feeding the liquid phase reagent into said vaporization apparatus;
(h) heating the liquid phase reagent in said vaporization apparatus to a temperature sufficient to vaporize the liquid phase reagent to provide said vapor phase reagent;
(i) feeding a carrier gas into said vaporization apparatus through said carrier gas feed line;
(j) withdrawing the vapor phase reagent and carrier gas from said vaporization apparatus through said vapor phase reagent discharge line; and
(k) feeding the vapor phase reagent and carrier gas into said deposition chamber.

5. The method of one of claims 1 and 4 further comprising:
contacting the vapor phase reagent with a substrate, optionally on a heatable susceptor, within the deposition chamber; and
discharging any remaining effluent through an effluent discharge line connected to the deposition chamber.

6. The method of one of claims 1 and 4 in which the deposition chamber is selected from a chemical vapor deposition chamber and an atomic layer deposition chamber.

7. The method of claim 5 wherein said substrate is comprised of a material selected from a metal, a metal silicide, a metal carbide, a metal nitride, a semiconductor, an insulator and a barrier material.

8. The method of claim 5 wherein said substrate is a patterned wafer.

9. The method of one of claims 1 and 4 wherein, tin the dispensing apparatus, the vessel is made of stainless steel.

10. The method of claim 4 wherein the tube comprises a dip tube and is made of stainless steel.

11. The method of one of claims 1 and 4 wherein, in the dispensing apparatus, the fastening means comprise engagement of a male nut (230) or body hex with a female nut (240).

12. The method of one of claims 1 and 4 in which said bottom wall member has a sump cavity therein extending downwardly from the surface of said bottom wall member.

13. The method of claim 12 wherein the dispensing apparatus further comprises:
a temperature sensor extending from said top wall member generally vertically downwardly through the inner gas volume into the source chemical, with the lower end of the temperature sensor being located in non-interfering proximity to the surface of the sump cavity;
a source chemical level sensor extending from a third face seal port opening on said top wall member generally vertically downwardly through the inner gas volume into the source chemical, with the lower end of the source chemical level sensor being located in non-interfering proximity to the surface of the sump cavity; and
the temperature sensor being operatively arranged in the vessel to determine the temperature of source chemical in the vessel, the source chemical level sensor being operatively arranged in the vessel to determine the level of source chemical in the vessel, the temperature sensor and source chemical level sensor being located in non-interfering proximity to each other in the vessel, with the lower end of the temperature sensor being located at the same or closer proximity to the surface of the sump cavity in relation to the lower end of the source chemical level sensor, and the temperature sensor and source chemical level sensor being in source chemical flow communication in the vessel.

14. The method of claim 4 wherein the liquid phase reagent dispensing apparatus further comprises the liquid phase reagent discharge line in liquid phase reagent flow communication with said vaporization apparatus, said vaporization apparatus in vapor phase reagent flow communication with a vapor phase delivery deposition system, said deposition system selected from a chemical vapor deposition system and an atomic layer deposition system.

15. The method of one of claims 1 and 4 wherein, in the dispensing apparatus, the vessel comprises a cylindrically shaped side wall member or side wall members defining a non-cylindrical shape.

16. The method of one of claims 1 and 4 wherein, in the dispensing apparatus, the source chemical comprises a liquid or solid material.

17. The method of one of claims 1 and 4 wherein, in the dispensing apparatus, the source chemical comprises a precursor for a metal selected from Group 2, Group 3, Group 4, Group 5, Group 6, Group 7, Group 8, Group 9, Group 10, Group 11, Group 12, Group 13, Group 14, Group 15, Group 16, and the Lanthanide series of the Periodic Table.

18. The method of one of claims 1 and 4 wherein, in the dispensing apparatus, the source chemical comprises a precursor for a metal selected from ruthenium, hafnium, tantalum, molybdenum, platinum, gold, titanium, lead, palladium, zirconium, bismuth, strontium, barium, calcium, antimony and thallium, or a precursor for a metalloid selected from silicon, germanium and tellurium.

19. The method of one of claims 1 and 4 wherein, in the dispensing apparatus, the vapor phase reagent comprises a precursor for a metal selected from Group 2, Group 3, Group 4, Group 5, Group 6, Group 7, Group 8, Group 9, Group 10, Group 11, Group 12, Group 13, Group 14, Group 15, Group 16, and the Lauthanide series of the Periodic Table.

20. The method of one of claims 1 and 4 wherein, in the dispensing apparatus, the vapor phase reagent comprises a precursor for a metal selected from ruthenium, hafnium, tantalum, molybdenum, platinum, gold, titanium, lead, palladium, zirconium, bismuth, strontium, barium, calcium, antimony and thallium, or a precursor for a metalloid selected from silicon, germanium and tellurium.

21. The method of one of claims 1 and 4 wherein the dispensing apparatus further comprises a carrier gas source coupled to the carrier gas feed line.

## Patentansprüche

1. Verfahren zur Abgabe eines Gasphasenreagens zu einer Abscheidekammer, wobei:
(a) eine Gasphasenreagensabgabevorrichtung zur Verfügung gestellt wird, mit:
einem Behälter, der ein oberes Wandteil, ein Seitenwandteil und ein unteres Wandteil aufweist, die ausgebildet sind, um ein inneres Behälterabteil zu bilden, um eine Quellenchemikalie bis zu einem Füllpegel zu halten und zusätzlich ein inneres Gasvolumen oberhalb des Füllpegels festzulegen;
wobei das obere Wandteil eine erste Flächenabdichtanschlussöffnuug (210), eine zweite Flächenabdichtanschluss6ffnung (110) und optional eine oder mehrere weitere Flächenabdichtanschlussöffnungen aufweist;
wobei die erste Flächenabdichtanschlussöffnung ein Trägergaszufuhreinlassanschlussstück (200) aufweist, welches damit verbunden ist;
einem Adapter (220) mit einer Metallflächenabdichtdichtung, die mit einem Rohr verbunden ist, welches sich durch die erste Flächenabdichtanschluss6ffnung und das innere Gasvolumen in die Quellenchexuikalie erstreckt und durch welches ein Trägergas in die Quellenchemikalie eingesprudelt werden kann, um zu bewirken, dass mindestens ein Teil von Quellenchemikaliendampf in dem Trägergas mitgerissen wird, um einen Gasphasenreagensstrom zu dem inneren Gasvolumen oberhalb des Füllpegels zu erzeugen, wobei das Rohr ein Einlassende (221) benachbart zu der ersten Flächenabdichtanschlussöffnung und ein Auslassende (224) benachbart zu dem unteren Wandteil aufweist;
wobei die erste Flächenabdichtanschlussöffnung und das Trägergaszufuhreinlassanschlussstück gegenüberliegende Oberflächen aufweisen, die nicht in Kontakt miteinander stehen;
wobei die Metallflächenabdichtdichtung bezüglich der gegenüberliegenden Oberflächen der ersten Flächenabdichtanschlussöffnung und des Trägergaszufuhreinlassanschlussstücks ausgerichtet ist und in Kontakt mit diesen steht;
Befestigungsmitteln (230, 240) zum Befestigen des Trägergaszufuhreinlassanschlussstücks in der ersten Flächenabdichtanschlussöffnung durch die gegenüberliegenden Oberflächen und die Metallflächenabdichtdichtung hindurch;
einer Trägergaszufuhrleitung, die sich außerhalb von dem Trägergaszufuhreinlassanschlussstück zwecks Abgabe von Trägergas in die Quellenchemikalie erstreckt und eines oder mehrere Trägergasstromsteuerventile zum Steuern des Durchstroms von Trägergas enthält;
wobei die zweite Flächenabdichtanschlussöffnung ein Gasphasenreagensauslassanschlussstück (100) aufweist, welches damit verbunden ist und durch welches das Gasphasenreagens aus der Vorrichtung abgegeben werden kann; und
einer Gasphasenreagensauslassleitung, die sich außerhalb von dem Gasphasenreagensauslassanschlussstück erstreckt, um Gasphasenreagens aus dem inneren Gasvolumen oberhalb des Füllpegels abzuziehen, und optional eines oder mehrere Gasphasenreagensstromsteuerventile zum Steuern des Durchstroms der Gasphasenreagens enthält;
(b) Quellenchemikalie der Gasphasenreagensabgabevorrichtung zugegeben wird;
(c) die Quellenchemikalie in der Dampfphasenreagensabgabevorrichtung auf eine Temperatur erwärmt wird, die hinreichend ist, um die Quellenchemikalie zu verdampfen, um Gasphasenreagens bereit zu stellen;
(d) ein Trägergas der Gasphasenreagensabgabevorrichtung durch die Trägergaszufuhrleitung und das Rohr zugeführt wird;
(e) das Gasphasenreagens und Trägergas aus der Gasphasenreagensabgabevorrichtung durch die Gasphasenreagensauslassleitung abgezogen wird; und
(f) das Gasphasenreagens und Trägergas in die Abscheidekammer eingeleitet werden.

2. Verfahren gemäß Anspruch 1, wobei es sich bei dem Rohr (220) um ein Einsprudelrohr handelt, welches aus rostfreiem Stahl gefertigt ist.

3. Verfahren gemäß Anspruch 1, wobei die Gasphasenreagensabgabevorrichtung ferner die Gasphasenreagensabgabeleitung in Gasphasenreagensstromverbindung mit einem Gasphasenzufuhrabscheidesystem aufweist, bei welchem es sich um ein CVD-System oder ein Atomlagenabscheidesystem handelt.

4. Verfahren zur Abgabe eines Gasphasenreagens in eine Abscheidekammer, wobei:
(a) eine Plüssigphasenreagensabgabevorrichtung bereitgestellt wird mit:
einem Behälter, welcher ein oberes Wandteil, ein Seitenwandteil und ein unteres Wandteil aufweist, die konfiguriert sind, um ein inneres Behälterabteil zu bilden, um eine Quellenchemikalie bis zu einem Füllpegel zu halten und zusätzlich ein inneres Gasvolumen oberhalb des Füllpegels festzulegen;
wobei das obere Wandteil eine erste Flächenabdichtanschlussöffnung (110), eine zweite Flächenabdichtanschlussöffnung (210) und optional eine oder mehrere weitere Flächenabdichtanschlussöffnungen aufweist;
wobei die erste Plächenabdichtanschlussöffnung ein Inertgaszuführeinlassanschtusssttick (100) aufweist, welches damit verbunden ist und durch welches ein Inertgas in das innere Gasvolumen oberhalb des Füllpegel eingeleitet werden kann, um das innere Gasvolumen oberhalb des Füllpegels unter Druck zu setzen;
wobei die zweite Flächenabdichtanschlussöffnung ein Flüssigphasenreagensauslassanschlussstück (200) aufweist, welches damit verbunden ist;
einem Adapter (220), der eine Metallflächenabdichtdichtung aufweist, die mit einem Rohr verbunden ist, welches sich durch die zweite Flächenabdichtanschlussöffnung und das innere Gasvolumen in die Quellenchemikalie erstreckt und durch welche Flüssigphasenreagens von der Vorrichtung ausgegeben werden kann, wobei das Rohr ein Auslassende (221) benachbart zu der zweiten Flächenabdichtanschlussöffnung und ein Einlassende (224) benachbart zu dem unteren Wandstück aufweist;
wobei die zweite Flächenabdichtanschlussöffnung und das Flüssigphasenreagensauslassanschlussstück gegenüberliegende Oberflächen aufweisen, die nicht im Kontakt miteinander stehen;
wobei die Metallflächenabdichtdichtung bezüglich der gegenüberliegenden Oberflächen der zweiten Flächenabdichtanschlussöffnung und dem Flüssigphasenreagensauslassanschlussstück ausgerichtet ist und in Kontakt mit diesen steht;
Befestigungsmitteln (230, 240) zum Befestigen des Flüssigphasenreagensauslassanschlussstücks in der zweiten Flächenabdichtanschlussöffnung durch die gegenüberliegenden Oberflächen und die Metallflächenabdichtdichtung hindurch;
einer Inertgaszufuhrleitung, die sich außerhalb von dem Inertgaszufuhreinlassanschlussstück erstreckt, um Inertgas in das innere Gasvolumen oberhalb des Füllpegels zuzuführen, und eines oder mehrere Inertgasstromsteuerventile zum Steuern des Durchstroms von Inertgas enthält; und
einer Flüssigphasenreagensauslassleitung, die sich außerhalb von dem Flüssigphasenreagensauslassanschlussstück erstreckt, um Flüssigphasenreagens von dem Behälter abzuziehen, und optional eines mehrere Flüssigphasenreagensstromsteuerventile zum Steuern des Durchstroms der Flüssigphasenreagens enthält;
(b) Flüssigphasenreagens zu der Flüssigphasenreagensabgabevorrichtung hinzugegeben wird;
(c) optional eine feste Quellenchemikalie in der Flüssigphasenreagensausgabevorrichtung optional auf eine Temperatur erwärmt wird, die hinreichend ist, um die feste Quellenchemikalie als Flüssigphasenreagens bereitzustellen;
(d) ein Inertgas durch die Inertgaszufixhrleitung in die Flüssigphasenreagensabgabevorrichtung eingeleitet wird;
(e) das Flüssigphasenreagens aus der Flüssigphasenreagensausgabevorrichtung durch das Rohr und die Flüssigphasenreagensauslassleitung abgezogen wird;
(f) eine Verdampfungsvorrichtung bereitgestellt wird mit:
einem Behälter, der konfiguriert ist, um ein inneres Behälterabteil zum Verdampfen des Flüssigphasenreagens zu bilden;
wobei die Flüssigphasenreagensauslassleitung die Flüssigphasenreagensabgabevorrichtung mit der Verdampfungsvorrichtung verbindet;
wobei ein Teil der Verdampfungsvorrichtung eine Trägergaszuführeinlassormung aufweist, durch welche Trägergas in die Verdampfungsvorrichtung eingeleitet werden kann, um dafür zu sorgen, dass Dampf des Flüssigphasenreagens in dem Trägergas mitgerissen wird, um Dampfphasenreagens zu erzeugen;
ein Teil der Verdampfungsvorrichtung eine Gasphasenreagensauslassöffnung aufweist, durch welche das Gasphasenreagens aus der Verdampfungsvorrichtung ausgegeben werden kann;
einer Trägergaszufuhrleitung, die sich von der Trägergaszufuhreinlasstiffnung außerhalb von der Verdampfungsvorrichtung erstreckt, um der Verdampfungsvorrichtung Trägergas zuzuführen, und eines oder mehrere Trägergasstromsteuerventile zum Steuern des Durchstroms des Trägergases enthält;
einer Dampfphasenreagensauslassleitung, welche sich von der Gasphasenreagensauslassöffnung außerhalb von der Verdampfungsvorrichtung erstreckt, um Gasphasenreagens aus der Verdampfungsvorrichtung zu der Abscheidekammer abzuziehen, und optional eines oder mehrere Dampfphasenreagensstromsteuerventile zum Steuern des Durchstroms der Gasphasenreagens enthält;
(g) das Flüssigphasenreagens in die Verdampfungsvorrichtung eingeleitet wird;
(h) das Flüssigphasenreagens in der Verdampfungsvorrichtung auf eine Temperatur erwärmt wird, die ausreichend ist, um das Flüssigphasenreagens zu verdampfen, um das Gasphasenreagens bereitzustellen;
(i) ein Trägergas durch die Trägergaszufuhrleitung in die Verdampfungsvorrichtung eingeleitet wird;
(j) das Gasphasenreagens und Trägergas aus der Verdampfungsvorrichtung durch die Gasphasenreagensauslassleitung abgezogen wird; und
(k) das Gasphasenreagens und Trägergas in die Abscheidekammer eingeleitet werden.

5. Verfahren gemäß einem der Ansprüche 1 und 4, wobei ferner:
das Gasphasenreagens mit einem Substrat, welches sich optional auf einem heizbaren Suszeptor befindet, innerhalb der Abscheidekammer in Kontakt gebracht wird; und
jeglicher verbleibende Abfluss durch eine mit der Abscheidekammer verbundene Abflussauslassleitung ausgeleitet wird.

6. Verfahren gemäß einem der Ansprüche 1 und 4, wobei es sich bei der Abscheidekammer um eine CVD-Kammer oder eine Atomlagenabscheidekammer handelt.

7. Verfahren gemäß Anspruch 5, wobei das Substrat von einem Material gebildet wird, welches aus einem Metall, einem Metallsilizid, einem Metallcarbid, einem Metallnitrid, einem Halbleiter, einem Isolator und einem Barrierenmaterial ausgewählt ist.

8. Verfahren gemäß Anspruch 5, wobei es sich bei dem Substrat um einen strukturierten Wafer handelt.

9. Verfahren gemäß einem der Ansprüche 1 und 4, wobei der Behälter in der Abgabevorrichtung aus rostfreiem Stahl gefertigt ist.

10. Verfahren gemäß Anspruch 4, wobei das Rohr ein Tauchrohr aufweist und aus rostfreiem Stahl gefertigt ist.

11. Verfahren gemäß einem der Ansprüche 1 und 4, wobei die Befestigungsmittel in der Abgabevorrichtung einen Eingriff eines Gewindebolzens (230) oder eines Body-Hex-Bolzens mit einer Mutter (240) aufweisen.

12. Verfahren gemäß einem der Ansprüche 1 und 4, wobei das untere Wandteil einen Sumpfhohlraum aufweist, welcher sich von der Oberfläche des unteren Wandteils darin nach unten erstreckt.

13. Verfahren gemäß Anspruch 12, wobei die Ausgabevorrichtung ferner versehen ist mit:
einem Temperatursensor, der sich von dem oberen Wandteil allgemein senkrecht nach unten durch das innere Gasvolumen in die Quellenchemikalie erstreckt, wobei das untere Ende des Temperatursensors in nicht-störender Nähe zu der Oberfläche des Sumpfhohlraums angeordnet ist;
einem Quellenchemikalienpegelsensor, der sich von einer dritten Flächenabdichtanschlussöffnung auf dem oberen Wandteil allgemein senkrecht nach unten durch das innere Gasvolumen in die Quellenchemikalie erstreckt, wobei das untere Ende des Quellenchemikalienpegelsensors in nicht-störender Nähe zu der Oberfläche des Sumpfhohlraums angeordnet ist; und
wobei der Temperatursensor in Wirkverbindung in dem Behälter angeordnet ist, um die Temperatur der Quellenchemikalie in dem Behälter zu bestimmen, wobei der Quellenchemikalienpegelsensor in Wirkverbindung in dem Behälter angeordnet ist, um den Pegel der Quellenchemikalie in dem Behälter zu bestimmen, wobei der Temperatursensor und der Quellenchemikalienpegelsensor in nicht-störender Nähe zueinander in dem Behälter angeordnet sind, wobei das untere Ende des Temperatursensors in gleicher oder näherer Nähe zu der Oberfläche des Sumpfhohlraums in Bezug auf das untere Ende des Quellenchemikalienpegelsensors angeordnet ist, und wobei der Temperatursensor und der Quellenchemikalienpegelsensor in Quellenchemikalienstromverbindung in dem Behälter stehen.

14. Verfahren gemäß Anspruch 4, wobei die Flüssigphasenreagensabgabevorrichtung ferner die Flüssigphasenreagensauslassleitung in Flüssigphasenreagensströmungsverbindung mit der Verdampfungsvorrichtung aufweist, wobei die Verdampfungsvorrichtung in Gasphasenreagensströmungsverbindung mit einem Gasphasenzufuhrabscheidesystem steht, bei welchem es sich um ein CVD-System oder ein Atomlagenabscheidesystem handelt.

15. Verfahren gemäß einem der Ansprüche 1 und 4, wobei der Behälter in der Abgabevorrichtung ein zylindrisch geformtes Seitenwandteil oder Seitenwandteile aufweist, die eine nicht zylindrische Form festlegen.

16. Verfahren gemäß einem der Ansprüche 1 und 4, wobei die Quellenchemikalie in der Ausgabevorrichtung ein flüssiges oder festes Material aufweist.

17. Verfahren gemäß einem der Ansprüche 1 und 4, wobei die Quellenchemikalie in der Ausgabevorrichtung Vorstufe für ein Metall aufweist, welches aus der Gruppe 2, Gruppe 3, Gruppe 4, Gruppe 5, Gruppe 6, Gruppe 7, Gruppe 8, Gruppe 9, Gruppe 10, Gruppe 11, Gruppe 12, Gruppe 13, Gruppe 14, Gruppe 15, Gruppe 16 und der Lanthanidenreihe des Periodensystems ausgewählt ist.

18. Verfahren gemäß einem der Ansprüche 1 und 4, wobei die Quellenchemikalie in der Ausgabevorrichtung eine Vorstufe für ein Metall aufweist, welches aus Ruthenium, Hafnium, Tantal, Molybdän, Platin, Gold, Titan, Blei, Palladium, Zirkonium, Bismut, Strontium, Barium, Calcium, Antimon und Thallium ausgewählt ist oder eine Vorstufe für ein Metalloid aufweist, welches aus Silizium, Germanium und Tellur ausgewählt ist.

19. Verfahren gemäß einem der Ansprüche 1 und 4, wobei das Gasphasenreagens in der Ausgabevorrichtung eine Vorstufe für ein Metall aufweist, welches aus der Gruppe 2, Gruppe 3, Gruppe, 4, Gruppe 5, Gruppe 6, Gruppe 7, Gruppe 8, Gruppe 9, Gruppe 10, Gruppe 11, Gruppe 12, Gruppe 13, Gruppe 14, Gruppe 15, Gruppe 16 und der Lanthanidenreihe des Periodensystems ausgewählt ist.

20. Verfahren gemäß einem der Ansprüche 1 und 4, wobei das Gasphasenreagens in der Ausgabevorrichtung eine Vorstufe für ein Metall, welches aus Ruthenium, Hafnium, Tantal, Molybdän, Platin, Gold, Titan, Blei, Palladium, Zirkonium, Bismut, Strontium, Barium, Calcium, Antimon und Thallium ausgewählt ist oder eine Vorstufe für ein Metalloid aufweist, welches aus Silizium, Germanium und Tellur ausgewählt ist.

21. Verfahren gemäß einem der Ansprüche 1 und 4, wobei die Ausgabevorrichtung ferner eine Trägergasquelle aufweist, die mit der Trägergaszufuhrleitung gekoppelt ist.

## Revendications

1. Procédé de distribution d'un réactif en phase vapeur dans une chambre de dépôt comprenant le fait :
(a) de prévoir un appareil de distribution de réactif en phase vapeur comprenant :
un récipient qui comprend un élément formant paroi supérieure, un élément formant paroi latérale et un élément formant paroi inférieure configurés pour former un compartiment interne du récipient pour contenir un produit chimique source jusqu'à un niveau de remplissage et pour définir par ailleurs un volume de gaz intérieur au-dessus du niveau de remplissage ;
ledit élément formant paroi supérieure ayant une première ouverture (210) de passage d'une garniture d'étanchéité, une deuxième ouverture (110) de passage d'une garniture d'étanchéité et éventuellement une ou plusieurs autres ouvertures de passage de garnitures d'étanchéité ;
ladite première ouverture de passage d'une garniture d'étanchéité ayant un raccord d'entrée (200) d'alimentation en gaz porteur qui lui est relié ;
un adaptateur (220) comprenant un joint d'étanchéité métallique relié à un tube qui s'étend à travers la première ouverture de passage d'une garniture d'étanchéité et ledit volume de gaz intérieur dans le produit chimique source et à travers lequel un gaz porteur peut être barboté dans le produit chimique source pour provoquer l'entraînement d'au moins une partie de la vapeur du produit chimique source dans ledit gaz porteur afin de produire un flux de réactif en phase vapeur audit volume de gaz intérieur au-dessus du niveau de remplissage, ledit tube ayant une extrémité d'entrée (221) adjacente à la première ouverture de passage d'une garniture d'étanchéité et une extrémité de sertie (224) adjacente à l'élément formant paroi inférieure ;
ladite première ouverture de passage d'une garniture d'étanchéité et ledit raccord d'entrée d'alimentation en gaz porteur présentant des surfaces opposées, les surfaces opposées n'étant pas en contact l'une avec l'autre ;
ledit joint d'étanchéité métallique étant aligné et en contact avec les surfaces opposées de ladite première ouverture de passage d'une garniture d'étanchéité et ledit raccord d'entrée d'alimentation en gaz porteur ;
des moyens de fixation (230, 240) pour fixer le raccord d'entrée d'alimentation en gaz porteur à ladite première ouverture de passage d'une garniture d'étanchéité à travers les surfaces opposées et ledit joint d'étanchéité métallique ;
une ligne d'alimentation en gaz porteur s'étendant à l'extérieur du raccord d'entrée d'alimentation en gaz porteur pour distribuer le gaz porteur dans ledit produit chimique source, la ligne d'alimentation en gaz porteur contenant une ou plusieurs soupapes de commande d'écoulement de gaz porteur pour commander l'écoulement du gaz porteur à travers celle-ci ;
ladite deuxième ouverture de passage d'une garniture d'étanchéité ayant un raccord (100) de sortie de réactif en phase vapeur qui lui est relié, à travers lequel ledit réactif en phase vapeur peut être distribué à partir dudit appareil ; et
une ligne d'évacuation de réactif en phase vapeur s'étendant à l'extérieur du raccord de sortie de réactif en phase vapeur pour retirer le réactif en phase vapeur dudit volume de gaz intérieur au-dessus du niveau de remplissage, la ligne d'évacuation de réactif en phase vapeur contenant éventuellement une ou plusieurs soupapes de commande d'écoulement de réactif en phase vapeur pour commander l'écoulement du réactif en phase vapeur à travers celle-ci ;
(b) d'ajouter le produit chimique source audit appareil de distribution de réactif en phase vapeur ;
(c) de chauffer le produit chimique source dans ledit appareil de distribution de réactif en phase vapeur à une température suffisante pour vaporiser le produit chimique source afin de fournir un réactif en phase vapeur ;
(d) d'alimenter un gaz porteur dans ledit appareil de distribution de réactif en phase vapeur à travers ladite ligne d'alimentation en gaz porteur et ledit tube ;
(e) de retirer le réactif en phase vapeur et le gaz porteur dudit appareil de distribution de réactif en phase vapeur à travers ladite ligne d'évacuation de réactif en phase vapeur ; et
(f) d'alimenter le réactif en phase vapeur et le gaz porteur dans ladite chambre de dépôt.

2. Procédé de la revendication 1, dans lequel le tube (220) constitue un tube de barbotage et est réalisé en acier inoxydable.

3. Procédé de la revendication 1, dans lequel l'appareil de distribution de réactif en phase vapeur comprend en outre la ligne d'évacuation de réactif en phase vapeur en communication de flux de réactif en phase vapeur avec un système de dépôt et de distribution en phase vapeur, ledit système de dépôt étant choisi parmi un système de dépôt chimique en phase vapeur ou un système de dépôt de couches atomiques.

4. Procédé permettant de distribuer un réactif en phase vapeur à une chambre de dépôt comprenant le fait :
(a) de fournir un appareil de distribution de réactif en phase liquide comprenant :
un récipient qui comprend un élément formant paroi supérieure, un élément formant paroi latérale et un élément formant paroi inférieure configurés pour former un compartiment interne du récipient pour contenir un produit chimique source jusqu'à un niveau de remplissage et pour définir par ailleurs un volume de gaz intérieur au-dessus du niveau de remplissage ;
ledit élément formant paroi supérieure ayant une première ouverture (110) de passage d'une garniture d'étanchéité, une deuxième ouverture (210) de passage d'une garniture d'étanchéité et éventuellement une ou plusieurs autres ouvertures de passage de garnitures d'étanchéité ;
ladite première ouverture de passage d'une garniture d'étanchéité ayant un raccord d'entrée (100) d'alimentation en gaz inerte qui lui est relié, à travers lequel un gaz inerte peut être alimenté dans le volume de gaz intérieur au-dessus du niveau de remplissage afin de mettre sous pression le volume de gaz intérieur au-dessus du niveau de remplissage ;
ladite deuxième ouverture de passage d'une garniture d'étanchéité ayant un raccord de sortie (200) de réactif en phase liquide qui lui relié ;
un adaptateur (220) comprenant un joint d'étanchéité métallique relié à un tube qui s'étend à travers la deuxième ouverture de passage d'une garniture d'étanchéité et le volume de gaz intérieur dans le produit chimique source et à travers lequel le réactif en phase liquide peut être distribué à partir dudit appareil, ledit tube ayant une extrémité de sortie (221) adjacente à la deuxième ouverture de passage d'une garniture d'étanchéité et une extrémité d'entrée (224) adjacente à l'élément formant paroi inférieure ;
ladite deuxième ouverture de passage d'une garniture d'étanchéité et ledit raccord de sortie de réactif en phase liquide présentant des surfaces opposées, les surfaces opposées n'entrant pas en contact l'une avec l'autre ;
ledit joint d'étanchéité métallique étant aligné et en contact avec les surfaces opposées de ladite deuxième ouverture de passage d'une garniture d'étanchéité et dudit raccord de sortie de réactif en phase liquide ;
des moyens de fixation (230, 240) pour fixer le raccord de sortie de réactif en phase liquide à ladite deuxième ouverture de passage d'une garniture d'étanchéité à travers les surfaces opposées et ledit joint d'étanchéité métallique ;
une ligne d'alimentation en gaz inerte s'étendant à l'extérieur du raccord d'entrée d'alimentation en gaz inerte pour distribuer du gaz inerte dans ledit volume de gaz intérieur au-dessus du niveau de remplissage, la ligne d'alimentation en gaz inerte contenant une ou plusieurs soupapes de commande d'écoulement de gaz inerte pour commander l'écoulement du gaz inerte à travers celle-ci ; et
une ligne d'évacuation de réactif en phase liquide s'étendant à l'extérieur du raccord de sortie de réactif en phase liquide pour retirer le réactif en phase liquide dudit récipient, la ligne d'évacuation de réactif en phase liquide contenant éventuellement une ou plusieurs soupapes de commande d'écoulement de réactif en phase liquide pour commander l'écoulement du réactif en phase liquide à travers celle-ci :
(b) d'ajouter un réactif en phase liquide audit appareil de distribution de réactif en phase liquide ;
(c) de chauffer éventuellement le produit chimique source solide dans ledit appareil de distribution de réactif en phase liquide à une température suffisante pour faire fondre le produit chimique source solide afin de fournir un réactif en phase liquide ;
(d) d'alimenter un gaz inerte dans ledit appareil de distribution de réactif en phase liquide à travers ladite ligne d'alimentation en gaz inerte ;
(e) de retirer le réactif en phase liquide dudit appareil de distribution de réactif en phase liquide à travers ledit tube et ladite ligne d'évacuation de réactif en phase liquide ;
(f) de fournir un appareil de vaporisation comprenant :
un récipient configuré pour former un compartiment de récipient interne afin de vaporiser le réactif en phase liquide ;
ladite ligne d'évacuation de réactif en phase liquide reliant l'appareil de distribution de réactif en phase liquide audit appareil de vaporisation ;
une partie de l'appareil de vaporisation ayant une ouverture d'entrée d'alimentation en gaz porteur à travers laquelle le gaz porteur peut être alimenté dans ledit appareil de vaporisation pour provoquer l'entraînement de la vapeur dudit réactif en phase liquide dans ledit gaz porteur afin de produire un réactif en phase vapeur ;
une partie de l'appareil de vaporisation ayant une ouverture de sortie de réactif en phase vapeur à travers laquelle ledit réactif en phase vapeur peut être distribué à partir dudit appareil de vaporisation ;
une ligne d'alimentation en gaz porteur s'étendant de l'ouverture d'entrée d'alimentation en gaz porteur de l'extérieur de l'appareil de vaporisation pour distribuer le gaz porteur dans ledit appareil de vaporisation, la ligne d'alimentation en gaz porteur contenant une ou plusieurs soupapes de commande d'écoulement de gaz porteur pour commander l'écoulement du gaz porteur à travers celle-ci ;
une ligne d'évacuation de réactif en phase vapeur s'étendant de l'ouverture de sortie de réactif en phase vapeur de l'extérieur de l'appareil de vaporisation pour éliminer le réactif en phase vapeur dudit appareil de vaporisation vers ladite chambre de dépôt, la ligne d'évacuation de réactif en phase vapeur contenant éventuellement une ou plusieurs soupapes de commande d'écoulement de réactif en phase vapeur pour commander l'écoulement du réactif en phase vapeur à travers celle-ci ;
(g) d'alimenter le réactif en phase liquide dans ledit appareil de vaporisation ;
(h) de chauffer le réactif en phase liquide dans ledit appareil de vaporisation à une température suffisante pour vaporiser le réactif en phase liquide afin de fournir ledit réactif en phase vapeur ;
(i) d'alimenter un gaz porteur dans ledit appareil de vaporisation à travers ladite ligne d'alimentation en gaz porteur ;
(j) de retirer le réactif en phase vapeur et le gaz porteur dudit appareil de vaporisation à travers ladite ligne d'évacuation de réactif en phase vapeur ; et
(k) d'alimenter le réactif en phase vapeur et le gaz porteur dans ladite chambre de dépôt.

5. Procédé de l'une des revendications 1 et 4, comprenant en outre le fait :
de mettre en contact le réactif en phase vapeur avec un substrat, éventuellement sur un suscepteur pouvant être chauffé, dans la chambre de dépôt ; et
d'évacuer tout effluent restant à travers une ligne d'évacuation d'effluent reliée à la chambre de dépôt.

6. Procédé de l'une des revendications 1 et 4, dans lequel la chambre de dépôt est choisie parmi une chambre de dépôt chimique en phase vapeur et une chambre de dépôt de couches atomiques.

7. Procédé de la revendication 5, dans lequel ledit substrat est constitué d'un matériau choisi parmi un métal, un siliciure métallique, un carbure métallique, un nitrure métallique, un semi-conducteur, un isolant et un matériau barrière.

8. Procédé de la revendication 5, dans lequel ledit substrat est une plaquette à motifs.

9. Procédé de l'une des revendications 1 et 4, dans lequel, dans l'appareil de distribution, le récipient est réalisé en acier inoxydable.

10. Procédé de la revendication 4, dans lequel le tube constitue un tube plongeur et est réalisé en acier inoxydable.

11. Procédé de l'une des revendications 1 et 4, dans lequel, dans l'appareil de distribution, les moyens de fixation comprennent l'engagement d'un écrou mâle (230) ou d'un corps hexagonal avec un écrou femelle (240).

12. Procédé de l'une des revendications 1 et 4, dans lequel ledit élément formant paroi inférieure contient une cavité de collecte s'étendant vers le bas depuis la surface de ladite paroi inférieure.

13. Procédé de la revendication 12, dans lequel l'appareil de distribution comprend en outre :
un capteur de température s'étendant dudit élément formant paroi supérieure de manière globalement verticale et descendante à travers le volume de gaz intérieur dans le produit chimique source, avec l'extrémité inférieure du capteur de température située à proximité de la surface de la cavité de collecte sans la toucher ;
un capteur de niveau de produit chimique source s'étendant d'une troisième ouverture de passage d'une garniture d'étanchéité sur ledit élément formant paroi supérieure de manière globalement verticale et descendante à travers le volume de gaz intérieur dans le produit chimique source, avec l'extrémité inférieure du capteur de niveau de produit chimique source située à proximité de la surface de la cavité de collecte sans la toucher ; et
le capteur de température étant agencé de manière fonctionnelle dans le récipient afin de déterminer la température du produit chimique source dans le récipient, le capteur de niveau de produit chimique source étant agencé de manière fonctionnelle dans le récipient afin de déterminer le niveau du produit chimique source dans le récipient, le capteur de température et le capteur de niveau de produit chimique source étant situés l'un à proximité de l'autre dans le récipient sans se toucher, avec l'extrémité inférieure du capteur de température située à un même niveau de proximité ou plus proche de la surface de la cavité de collecte par rapport à l'extrémité inférieure du capteur de niveau de produit chimique source, et le capteur de température et le capteur du niveau de produit chimique source étant en communication de flux de produit chimique source dans le récipient.

14. Procédé de la revendication 4, dans lequel l'appareil de distribution de réactif en phase liquide comprend en outre la ligne d'évacuation de réactif en phase liquide en communication de flux de réactif en phase liquide avec ledit appareil de vaporisation, ledit appareil de vaporisation étant en communication de flux de réactif en phase vapeur avec un système de dépôt et de distribution en phase vapeur, ledit système de dépôt étant choisi parmi un système de dépôt chimique en phase vapeur et un système de dépôt de couches atomiques.

15. Procédé de l'une des revendications 1 et 4, dans lequel, dans l'appareil de distribution, le récipient comprend un élément formant paroi latérale de forme cylindrique ou des éléments de paroi latérale définissant une forme non cylindrique.

16. Procédé de l'une des revendications 1 et 4, dans lequel, dans l'appareil de distribution, le produit chimique source comprend un matériau liquide ou solide.

17. Procédé de l'une des revendications 1 et 4, dans lequel, dans l'appareil de distribution, le produit chimique source comprend un précurseur pour un métal sélectionné à partir du Groupe 2, Groupe 3, Groupe 4, Groupe 5, Groupe 6, Groupe 7, Groupe 8, Groupe 9, Groupe 10, Groupe 11, Groupe 12, Groupe 13, Groupe 14, Groupe 15, Groupe 16, et de la série des lanthanides du tableau périodique.

18. Procédé de l'une des revendications 1 et 4, dans lequel, dans l'appareil de distribution, le produit chimique source comprend un précurseur pour un métal choisi parmi le ruthénium, l'hafnium, le tantale, le molybdène, le platine, l'or, le titane, le plomb, le palladium, le zirconium, le bismuth, le strontium, le baryum, le calcium, l'antimoine et le thallium, ou un précurseur pour un métalloïde choisi parmi le silicium, le germanium et le tellure.

19. Procédé de l'une des revendications 1 et 4, dans lequel, dans l'appareil de distribution, le réactif en phase vapeur comprend un précurseur pour un métal sélectionné à partir du Groupe 2, Groupe 3, Groupe 4, Groupe 5, Groupe 6, Groupe 7, Groupe 8, Groupe 9, Groupe 10, Groupe 11, Groupe 12, Groupe 13, Groupe 14, Groupe 15, Groupe 16, et de la série des lanthanides du tableau périodique.

20. Procédé de l'une des revendications 1 et 4, dans lequel, dans l'appareil de distribution, le réactif en phase vapeur comprend un précurseur pour un métal choisi parmi le ruthénium, l'hafnium, le tantale, le molybdène, le platine, l'or, le titane, le plomb, le palladium, le zirconium, le bismuth, le strontium, le baryum, le calcium, l'antimoine et le thallium, ou un précurseur pour un métalloïde choisi parmi le silicium, le germanium et le tellure.

21. Procédé de l'une des revendications 1 et 4, dans lequel l'appareil de distribution comprend en outre une source de gaz porteur couplée à la ligne d'alimentation en gaz porteur.
